# EUROPÄISCHE PATENTSCHRIFT

(11) **EP 4 402 710 B1**
(45) Veröffentlichungstag und Bekanntmachung des Hinweises auf die Patenterteilung: **30.09.2026**
(21) Anmeldenummer: 22764650.2
(22) Anmeldetag: 31.08.2022
(51) Int. Cl.: H01J 37/244, H01J 37/28

(54) **VERFAHREN ZUM BETREIBEN EINES VIELSTRAHL-TEILCHENMIKROSKOPS IN EINEM KONTRAST-BETRIEBSMODUS MIT DEFOKUSSIERTER STRAHLFÜHRUNG, COMPUTERPROGRAMMPRODUKT UND VIELSTRAHLTEILCHENMIKROSKOP**
METHOD FOR OPERATING A MULTI-BEAM PARTICLE MICROSCOPE IN A CONTRAST OPERATING MODE WITH DEFOCUSED BEAM GUIDING, COMPUTER PROGRAM PRODUCT, AND MULTI-BEAM PARTICLE MICROSCOPE
PROCÉDÉ DE FONCTIONNEMENT D'UN MICROSCOPE À PARTICULES À FAISCEAUX MULTIPLES DANS UN MODE DE FONCTIONNEMENT PAR CONTRASTE AVEC GUIDAGE DE FAISCEAU DÉFOCALISÉ, PRODUIT-PROGRAMME INFORMATIQUE ET MICROSCOPE À PARTICULES À FAISCEAUX MULTIPLES

(30) Priorität: 17.09.2021 DE 102021124099
(43) Veröffentlichungstag der Anmeldung: 24.07.2024
(73) Patentinhaber: Carl Zeiss MultiSEM GmbH, 73447 Oberkochen (DE)
(72) Erfinder: SCHUBERT, Stefan, 73447 Oberkochen (DE)
(74) Vertreter: Tesch-Biedermann, Carmen
(86) Internationale Anmeldenummer: PCT/EP2022/025403
(87) Internationale Veröffentlichungsnummer: WO 2023/041191

(56) Entgegenhaltungen:
- WO-A1-2018/145983
- JP-A- 2011 192 498
- US-A1- 2017 316 912
- US-A1- 2019 355 544

## Beschreibung

### Gebiet der Erfindung

Die Erfindung bezieht sich auf ein Verfahren zum Betreiben eines Vielstrahl-Teilchenmikroskops in einem Kontrast-Betriebsmodus mit defokussierter Strahlführung sowie auf ein zugehöriges Computerprogrammprodukt sowie auf ein Vielstrahl-Teilchenmikroskop.

### Stand der Technik

Mit der kontinuierlichen Entwicklung immer kleinerer und komplexerer Mikrostrukturen wie Halbleiterbauelementen besteht ein Bedarf an der Weiterentwicklung und Optimierung von planaren Herstellungstechniken und von Inspektionssystemen zur Herstellung und Inspektion kleiner Abmessungen der Mikrostrukturen. Die Entwicklung und Herstellung der Halbleiterbauelemente erfordert beispielsweise eine Überprüfung des Designs von Testwafern, und die planaren Herstellungstechniken benötigen eine Prozessoptimierung für eine zuverlässige Herstellung mit hohem Durchsatz. Darüber hinaus wird neuerdings eine Analyse von Halbleiterwafern für das Reverse Engineering und eine kundenspezifische, individuelle Konfiguration von Halbleiterbauelementen gefordert. Es besteht deshalb ein Bedarf an Inspektionsmitteln, die mit hohem Durchsatz zur Untersuchung der Mikrostrukturen auf Wafern mit hoher Genauigkeit eingesetzt werden können.

Typische Siliziumwafer, die bei der Herstellung von Halbleiterbauelementen verwendet werden, haben Durchmesser von bis zu 300 mm. Jeder Wafer ist in 30 bis 60 sich wiederholende Bereiche ("Dies") mit einer Größe von bis zu 800 mm² unterteilt. Eine Halbleitervorrichtung umfasst mehrere Halbleiterstrukturen, die durch planare Integrationstechniken in Schichten auf einer Oberfläche des Wafers hergestellt sind. Aufgrund der Herstellungsprozesse weisen Halbleiterwafer typischerweise eine ebene Oberfläche auf. Die Strukturgröße der integrierten Halbleiterstrukturen erstreckt sich dabei von wenigen µm bis zu den kritischen Abmessungen (engl. "critical dimensions", CD) von 5 nm, wobei in naher Zukunft die Strukturgrößen sogar noch kleiner werden; man rechnet zukünftig mit Strukturgrößen oder kritische Abmessungen (CD) unter 3 nm, beispielsweise 2 nm, oder sogar unter 1nm. Bei den oben genannten kleinen Strukturgrößen müssen Defekte in der Größe der kritischen Abmessungen in kurzer Zeit auf einer sehr großen Fläche identifiziert werden. Für mehrere Anwendungen ist die Spezifikationsanforderung für die Genauigkeit einer von einem Inspektionsgerät bereitgestellten Messung sogar noch höher, beispielsweise um den Faktor zwei oder eine Größenordnung. Beispielsweise muss eine Breite eines Halbleitermerkmals mit einer Genauigkeit unter 1 nm, beispielsweise 0,3 nm oder sogar weniger, gemessen werden, und eine relative Position von Halbleiterstrukturen muss mit einer Überlagerungsgenauigkeit von unter 1 nm, beispielsweise 0,3 nm oder sogar weniger, bestimmt werden.

Eine neuere Entwicklung auf dem Gebiet der geladenen Teilchensysteme (engl. "charged particle microscopes", CPM) ist das MSEM, ein Mehrstrahl-Rasterelektronenmikroskop. Ein Mehrstrahl-Rasterelektronenmikroskop ist beispielsweise in US 7 244 949 B2 und in US 2019/0355544 A1 offenbart. In einem Mehrstrahl-Elektronenmikroskop oder MSEM wird eine Probe mit einer Vielzahl von Einzel-Elektronenstrahlen, die in einem Feld oder Raster angeordnet sind, gleichzeitig bestrahlt. Es können beispielsweise 4 bis 10000 Einzel-Elektronenstrahlen als Primärstrahlung vorgesehen sein, wobei jeder Einzel-Elektronenstrahl durch einen Abstand von 1 bis 200 Mikrometern von einem benachbarten Einzel-Elektronenstrahl getrennt ist. Zum Beispiel hat ein MSEM ungefähr 100 getrennte Einzel-Elektronenstrahlen (engl. "beamlets"), die beispielsweise in einem hexagonalen Raster angeordnet sind, wobei die Einzel-Elektronenstrahlen durch einen Abstand von ungefähr 10 µm getrennt sind. Die Vielzahl von geladenen Einzel-Teilchenstrahlen (Primärstrahlen) wird durch eine gemeinsame Objektivlinse auf eine Oberfläche einer zu untersuchenden Probe fokussiert. Die Probe kann zum Beispiel ein Halbleiterwafer sein, der an einem Waferhalter befestigt ist, der auf einem beweglichen Tisch montiert ist. Während der Beleuchtung der Waferoberfläche mit den geladenen primären Einzel-Teilchenstrahlen gehen Wechselwirkungsprodukte, z.B. Sekundärelektronen oder Rückstreuelektronen, von der Oberfläche des Wafers aus. Ihre Startpunkte entsprechen den Orten auf der Probe, auf die die Vielzahl von primären Einzel-Teilchenstrahlen jeweils fokussiert ist. Die Menge und Energie der Wechselwirkungsprodukte hängt von der Materialzusammensetzung und der Topographie der Waferoberfläche ab. Die Wechselwirkungsprodukte bilden mehrere sekundäre Einzel-Teilchenstrahlen (Sekundärstrahlen), die von der gemeinsamen Objektivlinse gesammelt und durch ein Projektionsabbildungssystem des Mehrstrahlinspektionssystems auf einen Detektor treffen, der in einer Detektionsebene angeordnet ist. Der Detektor umfasst mehrere Detektionsbereiche, von denen jeder mehrere Detektionspixel umfasst, und der Detektor erfasst eine Intensitätsverteilung für jeden der sekundären Einzel-Teilchenstrahlen. Dabei wird ein Bildfeld von beispielsweise 100 µm × 100 µm erhalten.

Das Mehrstrahl-Elektronenmikroskop des Standes der Technik umfasst eine Folge von elektrostatischen und magnetischen Elementen. Zumindest einige der elektrostatischen und magnetischen Elemente sind einstellbar, um die Fokusposition und die Stigmation der Vielzahl von geladenen Einzel-Teilchenstrahlen anzupassen. Das Mehrstrahl-System mit geladenen Teilchen des Standes der Technik umfasst zudem mindestens eine Überkreuzungsebene der primären oder der sekundären geladenen Einzel-Teilchenstrahlen. Des Weiteren umfasst das System des Standes der Technik Detektionssysteme, um die Einstellung zu erleichtern. Das Mehrstrahl-Teilchenmikroskop des Standes der Technik umfasst mindestens einen Strahlablenker (engl. "deflection scanner") zum kollektiven Abtasten eines Bereiches der Probenoberfläche mittels der Vielzahl von primären Einzel-Teilchenstrahlen, um ein Bildfeld der Probenoberfläche zu erhalten. Weitere Einzelheiten über ein Mehrstrahl-Elektronenmikroskops und über ein Verfahren zum Betreiben desselben sind in der deutschen Patentanmeldung mit der Anmeldenummer 102020206739.2, eingereicht am 28. Mai 2020, sowie in den zugehörigen Patentfamiliendokumenten beschrieben.

Die Inspektionsaufgaben, bei denen Mehrstrahl-Elektronenmikroskope bzw. allgemeiner Vielstrahl-Teilchenmikroskope eingesetzt werden, haben je nach Anwendung oder Probe unterschiedliche Anforderungen zu erfüllen. Beispielsweise kann es eine Aufgabenstellung sein, mit hoher Geschwindigkeit ein Übersichtsbild einer Probe zu erhalten (z.B. in einem Normal-Betriebsmodus bzw. Normal-Inspektionsmodus). Es ist aber auch möglich, dass speziell interessante Bereiche einer Probe genauer untersucht werden sollen. Fragestellungen hierbei beziehen sich beispielsweise auf den exakten Verlauf von Kanten (topographischer Kontrast oder Kantenkontrast), auf Materialgrenzen in der Probe (Materialkontrast) oder auf örtliche Aufladungen der Probe (Aufladungskontrast). In einem sog. Kontrast-Betriebsmodus wird im Projektionspfad bzw. Sekundärpfad des Vielstrahl-Teilchenmikroskops im Bereich einer Strahlüberkreuzung der Sekundärstrahlen (sog. Cross-Over; Pupillenebene) eine Kontrastapertur angeordnet, die ein Filtern der von der Probe startenden oder ausgehenden Sekundärteilchen nach ihren Startwinkeln bzw. allgemeiner nach ihrem Bahnverlauf ermöglicht. Verschiedene Kontraste können durch Auswahl und/ oder Kombination verschiedener Kontrastaperturen untersucht werden. Die Sekundärteilchen bzw. zweiten Einzel-Teilchenstrahlen treffen nach dem Durchsetzen der Kontrastapertur(en) jeweils fokussiert auf Detektionsbereiche des Detektors. Nähere Einzelheiten hierzu sind beispielsweise in der DE 2015 202 172 B4 beschrieben.

Gemäß dem Stand der Technik ist es erforderlich, zum Erhalten von unterschiedlicher Kontrastinformation (Kantenkontrast, Materialkontrast, Spannungskontrast) mehrere Aufnahmen mit unterschiedlichen Einstellungen zu machen. Zum Erhalten eines Kantenkontrasts sind andere Einstellungen vorteilhaft bzw. notwendig als zum Erhalten eines Materialkontrasts oder Spannungskontrasts. Außerdem ist es allgemein wünschenswert, Kontrastaufnahmen weiter zu verbessern.

Martin Kienle, Aufbau und Erprobung eines außeraxialen Vielkanalspektrometers für Sekundärelektronen, Dissertation, Universität Tübingen, 2002, offenbart bei einer Justage eines Vielkanalspektrometer einen defokussierten Einfall von Sekundärteilchen auf einen Lichtleiter.

### Beschreibung der Erfindung

Es ist somit die Aufgabe der vorliegenden Erfindung, ein verbessertes Verfahren zum Betreiben eines Vielstrahl-Teilchenmikroskopes in einem Kontrast-Betriebsmodus vorzuschlagen. Das Verfahren soll insbesondere die Generierung von Kontrastinformation erleichtern und/ oder verbessern. Außerdem soll es prinzipiell möglich sein, mittels eines einzigen Scans/ einer einzigen Aufnahme unterschiedliche Kontrastinformation zu erhalten.

Die Aufgabe wird gelöst durch die unabhängigen Patentansprüche. Vorteilhafte Ausführungsformen der Erfindung gehen aus den abhängigen Patentansprüchen hervor.

Die vorliegende Patentanmeldung beansprucht die Priorität der deutschen Patentanmeldung mit der Anmeldenummer 10 2021 124 099.9 vom 17. September 2021, deren Offenbarung vollumfänglich durch Inbezugnahme in die vorliegende Patentanmeldung mit aufgenommen wird.

Der Erfindung liegt unter anderem die Überlegung zugrunde, dass Kontrastinformation im Winkelspektrum der sekundären Teilchenstrahlen enthalten ist, die bei den bisher existierenden Kontrast-Betriebsmodi nicht genutzt wird. Stattdessen geht diese Kontrastinformation bei der fokussierten Abbildung der Sekundärstrahlen auf den Detektor verloren. Im Umkehrschluss erlaubt die Erfindung die Nutzung dieser Information aus dem Winkelspektrum. Genauer gesagt ermöglicht die Erfindung nicht nur die Nutzung von Winkelinformation aus dem Winkelspektrum, sondern auch von Richtungsinformation. Diese Information wird dann zugänglich, wenn die Abbildung der sekundären Teilchenstrahlen auf einen Detektor absichtlich nicht fokussiert, sondern defokussiert erfolgt und wenn der sich dadurch vergrößernden Auftrefffläche auf dem Detektor (Detektionsbereich) verschiedene Detektionskanäle zugeordnet werden, deren jeweilige Signale eine Auswertung der Winkel-und/ oder Richtungsinformation erlauben.

Gemäß einem ersten Aspekt der Erfindung bezieht sich diese auf ein Verfahren zum Betreiben eines Vielstrahl-Teilchenmikroskops, das die folgenden Schritte aufweist:
Betreiben des Vielstrahl-Teilchenmikroskops in einem Kontrast-Betriebsmodus, wobei in dem Kontrast-Betriebsmodus im Sekundärpfad des Vielstrahl-Teilchenmikroskops im Bereich einer Strahlüberkreuzung der Sekundärstrahlen eine Kontrastapertur angeordnet ist, die ein Filtern von von einem Objekt startenden oder ausgehenden Sekundärteilchen nach ihren Startwinkeln ermöglicht; umfassend die folgenden Schritte:
Bestrahlen eines Objektes mit einer Vielzahl von geladenen ersten Einzel-Teilchenstrahlen, wobei jeder erste Einzel-Teilchenstrahl einen separaten Einzelfeldbereich des Objektes rasternd bestrahlt;
Aufsammeln von zweiten Einzel-Teilchenstrahlen, die aufgrund der ersten Einzel-Teilchenstrahlen aus dem Objekt austreten oder von ihm ausgehen;
Defokussiertes Projizieren der zweiten Einzel-Teilchenstrahlen auf Detektionsbereiche einer Detektionseinheit derart, dass die von zwei verschiedenen Einzelfeldbereichen austretenden oder ausgehenden zweiten Einzel-Teilchenstrahlen auf verschiedene Detektionsbereiche projiziert werden, wobei jedem Detektionsbereich eine Mehrzahl von Detektionskanälen zugeordnet ist, wobei die Detektionskanäle jeweils Winkelinformation und/ oder Richtungsinformation der zweiten Einzel-Teilchenstrahlen beim Starten von dem Objekt kodieren, wobei bei dem defokussierenden Projizieren der zweiten Einzel-Teilchenstrahlen auf die Detektionsbereiche der Detektionseinheit ein Übersprechen der zweiten Einzel-Teilchenstrahlen vermieden wird; und
Erzeugen von Einzelbildern von jedem der Einzelfeldbereiche basierend auf Daten, die mittels Signalen aus jedem der Detektionsbereiche mit ihren jeweils zugeordneten Detektionskanälen gewonnenen werden oder gewonnen worden sind.

Bei den ersten geladenen Einzel-Teilchenstrahlen kann es sich zum Beispiel um Elektronen,

Positronen oder Ionen oder andere geladene Partikel handeln. Die jedem ersten Einzel-Teilchenstrahl zugeordneten Einzelfeldbereiche des Objekts werden rasternd, z.B. zeilenweise oder spaltenweise, abgescannt. Dabei ist es bevorzugt so, dass die Einzelfeldbereiche einander benachbart sind bzw. das Objekt oder einen Teil desselben kachelnd abdecken. Die Einzelfeldbereiche sind im Wesentlichen separat voneinander, sie können aber in den Randbereichen miteinander überlappen. Auf diese Weise ist es möglich, ein möglichst vollständiges und zusammenhängendes Bild des Objekts zu erhalten. Bevorzugt sind die Einzelfeldbereiche rechteckig oder quadratisch ausgebildet, da dies für den Abtastvorgang mithilfe der Teilchenstrahlung am einfachsten zu realisieren ist. Bevorzugt sind die Einzelfeldbereiche als Rechtecke in verschiedenen Zeilen übereinander derart angeordnet, sodass sich insgesamt eine hexagonale Struktur ergibt. Es ist vorteilhaft, wenn die Zahl der Teilchenstrahlen 3n (n-1)+1, mit n einer beliebigen natürlichen Zahl, im hexagonalen Fall beträgt. Andere Anordnungen der Einzelfeldbereiche, z.B. in einem quadratischen oder rechteckigen Raster, sind ebenfalls möglich.

Bei den zweiten Einzel-Teilchenstrahlen kann es sich um Rückstreuelektronen oder aber um Sekundärelektronen handeln. Dabei ist es für Analysezwecke bevorzugt so, dass die niederenergetischen Sekundärelektronen für die Bilderzeugung verwendet werden. Es ist aber auch möglich, dass Spiegel-Ionen/ Spiegelelektronen als zweite Einzel-Teilchenstrahlen verwendet werden, also direkt vor bzw. an dem Objekt umkehrende erste Einzel-Teilchenstrahlen.

Erfindungsgemäß erfolgt ein defokussiertes Projizieren der zweiten Einzel-Teilchenstrahlen auf Detektionsbereiche einer Detektionseinheit derart, dass die von zwei verschiedenen Einzelfeldbereichen austretenden oder ausgehenden zweiten Einzel-Teilchenstrahlen auf verschiedene Detektionsbereiche projiziert werden, wobei jedem Detektionsbereich eine Mehrzahl von Detektionskanälen zugeordnet ist, wobei die Detektionskanäle jeweils Winkelinformation und/oder Richtungsinformation der zweiten Einzel-Teilchenstrahlen beim Starten von dem Objekt codieren. Auch bei dem defokussierten Projizieren der zweiten Einzel-Teilchenstrahlen auf Detektionsbereiche einer Detektionseinheit wird also ein Übersprechen (Cross-Talk) der zweiten Einzel-Teilchenstrahlen miteinander vermieden, ganz so, wie dies bereits vom Betreiben eines Vielstrahl-Teilchenmikroskopes in einem Normal-Betriebsmodus/Inspektionsmodus bekannt ist. Durch das Defokussieren vergrößern sich allerdings die tatsächlichen Auftreffbereiche und somit die Detektionsbereiche je zweitem Einzel-Teilchenstrahl. Dadurch kann Information, die im Winkelspektrum der zweiten Einzel-Teilchenstrahlen vorhanden ist, bei der Detektion erhalten bleiben. Wichtig ist dafür das Vorsehen von einer Mehrzahl von Detektionskanälen, dies können beispielsweise zwei, drei, vier, fünf, sechs oder mehr Detektionskanäle pro Detektionsbereich sein. Diese Detektionskanäle haben nun die Eigenschaft, dass sie jeweils Winkelinformation und/oder Richtungsinformation der zweiten Einzel-Teilchenstrahlen beim Starten von dem Objekt codieren. Abhängig von der Startrichtung und/oder dem Startwinkel treffen die zweiten Einzel-Teilchenstrahlen nämlich auf verschiedene Detektionskanäle auf. Es erfolgt eine ortsaufgelöste Detektion. Von einer richtungs-sensitiven Detektion kann beispielsweise dann gesprochen werden, wenn die Detektionskanäle so angeordnet sind, dass das Auftreffen von Teilchen der zweiten Einzel-Teilchenstrahlen untergliedert werden kann in beispielsweise oben, unten, links und rechts (entsprechend vier Sektoren) oder aber schräg oben links, schräg oben rechts oder mittig unten (drei Sektoren). Die Detektionskanäle können dabei durch eine Sektorierung von Detektionsbereichen gebildet werden. Der Begriff Detektionskanal bezieht sich in diesem Zusammenhang dann auf die Auftreffoberfläche des Detektionsbereiches. Der Begriff Detektionskanal kann aber - je nach Kontext - auch die Signalauswertung im Zuge der Detektion umfassen. Ein Signal wird nämlich für jeden Detektionskanal im Prinzip separat generiert. Pro Detektionsbereich werden also mehrere Signale aus der entsprechenden Mehrzahl von Detektionskanälen generiert. Winkelinformation über die zweiten Einzel-Teilchenstrahlen beim Starten von dem Objekt kann beispielsweise über radial sensitive Detektionskanäle gewonnen werden, zum Beispiel durch kreisförmige bzw. konzentrisch ringförmig angeordnete Kanäle (Beispiel für einen schalenartiger Aufbau). Gemäß einer bevorzugten Ausführungsform erlauben es die Detektionskanäle, sowohl Richtungsinformation als auch Winkelinformation zu codieren, sie sind dann richtungs-sensitiv und radial sensitiv. Beispiele hierfür werden weiter unten noch detaillierter dargelegt.

Das Erzeugen von Einzelbildern von jedem der Einzelfeldbereiche erfolgt erfindungsgemäß basierend auf Daten, die mittels Signalen aus jedem der Detektionsbereiche mit ihren jeweils zugeordneten Detektionskanälen gewonnen werden oder gewonnen worden sind. In das Erzeugen von Einzelbildern gehen also nicht nur pauschal die Signale aus jedem der Detektionsbereiche durch bloße Addition sämtlicher Signale der Detektionskanäle des gesamten Detektionsbereiches ein, sondern zum Erzeugen der Einzelbilder werden nach einem geeigneten Algorithmus Signale aus jedem der Detektionskanäle je Detektionsbereich verwendet. Dabei ist es möglich, die Einzelbilder quasi sofort zu erzeugen, es ist aber auch möglich, die Daten zu speichern und die Einzelbilder daraus erst später zu erzeugen. Dadurch wird es auch möglich, basierend auf einmal vorhandenen Daten bzw. Signalen verschiedene Einzelbilder für verschiedene Kontrastmodi zu erhalten.

Gemäß einer bevorzugten Ausführungsform der Erfindung weist das erfindungsgemäße Verfahren des Weiteren im Kontrast-Betriebsmodus die folgenden Schritte auf:
Festlegen von Gewichtungen für Signale aus jedem Detektionskanal; und
Mixen der Signale aus den Detektionskanälen zu einem Mix-Signal des zugeordneten Detektionsbereichs basierend auf den Gewichtungen.

Es ist also möglich, je nach Aufgabenstellung die Signale aus jedem Detektionskanal verschieden zu gewichten und dadurch die Ortsauflösung der Signale zu berücksichtigen. Winkelinformation und/ oder Richtungsinformation kann entsprechend verarbeitet werden. Durch das Mixen der Signale ist es möglich, Signale aus verschiedenen Detektionskanälen beispielsweise gezielt zu addieren oder voneinander abzuziehen. Es ist auch möglich, Durchschnittswerte oder Medianwerte zu ermitteln, Maxima oder Minima können ebenso ermittelt werden. Das Mix-Signal eines Detektionsbereichs wird also je nach Fragestellung basierend auf den Signalen seiner Detektionskanäle zusammengesetzt. Die Technik des Mixens von Signalen ist im Prinzip aus dem Stand der Technik bekannt. Nähere Ausführungen hierzu finden sich beispielsweise in der US 10,192,716 B2 sowie in der US 10,186,399 B2. Einfache Grundprinzipien zu einer winkelabhängigen Detektion von Sekundärelektronen bei einem Einzelstrahlsystem sind auch bereits aus dem Lehrbuch von Ludwig Reimer, "Scanning Electron Microscopy", Springer-Verlag Berlin Heidelberg 1985, 1998, bekannt.

Gemäß einer bevorzugten Ausführungsform der Erfindung weist das Verfahren im Kontrast-Betriebsmodus des Weiteren den folgenden Schritt auf:
Auswählen einer Kontrastblende, die im Sekundärpfad des Vielstrahl-Teilchenmikroskopes im Bereich einer Strahlüberkreuzung der zweiten Einzel-Teilchenstrahlen angeordnet ist oder angeordnet wird.

Bei der Kontrastblende kann es sich zum Beispiel um eine Kreisblende oder um eine Ringblende handeln, es kann sich um eine Hellfeldblende oder um eine Dunkelfeldblende handeln. Es ist möglich, nicht nur eine, sondern mehrere gleiche oder verschiedene Kontrastblenden vorzusehen, die nacheinander von den zweiten Einzel-Teilchenstrahlen durchsetzt werden. Es ist möglich, dass sich die Kontrastblende bereits im Strahlengang der zweiten Einzel-Teilchenstrahlen befindet und die Auswahl dadurch erfolgt, dass die zweiten Einzel-Teilchenstrahlen entsprechend abgelenkt werden. Dies kann beispielsweise durch einen Parallelversatz der zweiten Einzel-Teilchenstrahlen im Sekundärpfad erfolgen. Es ist aber auch möglich, dass eine Kontrastblende erst in den Strahlengang eingebracht, zum Beispiel hineingefahren oder in die gewünschte Position rotiert wird. Dann kann das Auswählen einer Kontrastblende das Einfahren einer speziell ausgewählten Kontrastblende (oder Kontrastblenden) in den Strahlengang umfassen. Verschiedene Kontrastblenden können sich beispielsweise in ihrem Durchmesser und/oder ihrer Kreisringbreite unterscheiden. In jedem Fall hat die Kontrastblende bzw. Kontrastapertur die Aufgabe, zweite Einzel-Teilchenstrahlen nach ihren Startwinkeln von der Objektebene zu filtern. Zweite Einzel-Teilchenstrahlen ab einem/bis hin zu einem bestimmten Startwinkelbereich werden aus dem Büschel der zweiten Einzel-Teilchenstrahlen in der Strahlüberkreuzung ausgeschnitten. Nähere Einzelheiten zur Bedeutung der Kontrastblende sowie zu ihren möglichen Ausgestaltungen sind beispielsweise der am 9. September 2020 angemeldeten deutschen Patentanmeldung mit der Anmeldenummer 10 2020 123 567.4 und dem deutschen Patent DE 2015 202 172 B4 zu entnehmen.

Gemäß einer weiteren bevorzugten Ausführungsform der Erfindung weist das Verfahren im Kontrast-Betriebsmodus des Weiteren den folgenden Schritt auf:
Einstellen der Defokussierung der zweiten Einzel-Teilchenstrahlen beim Auftreffen auf die Detektionseinheit, insbesondere basierend auf der ausgewählten Kontrastblende. Dadurch kann die Defokussierung stärker oder weniger stark gewählt werden. Je stärker die Defokussierung gewählt wird, desto detaillierter lässt sich Winkel- und/oder Richtungsinformation der zweiten Einzel-Teilchenstrahlen detektieren. Umgekehrt wird das Signal je Detektionskanal dann aber auch schwächer und bei Verwendung derselben Anzahl von Einzel-Teilchenstrahlen steigt der Flächenbedarf der Detektionseinheit an. Je nach Informationsbedarf und/oder Ausgestaltung der Detektionseinheit kann die Defokussierung also entsprechend ausgewählt werden. Dies kann manuell durch einen Benutzer erfolgen, es ist aber auch möglich, dass die Einstellung der Defokussierung automatisch aufgrund von bekannten bzw. hinterlegten Parametern über die Probe/das Inspektionsziel erfolgt. Das Einstellen der Defokussierung selbst kann über eine entsprechende Ansteuerung des Projektionslinsensystems im Sekundärpfad des Vielstrahl-Teilchenstrahlmikroskops erfolgen.

Gemäß einer weiteren bevorzugten Ausführungsform der Erfindung umfasst das Verfahren im Kontrast-Betriebsmodus des Weiteren den folgenden Schritt:
Auswählen einer Anzahl von Detektionskanälen je Detektionsbereich.

Das Auswählen einer Anzahl von Detektionskanälen kann dabei an die eingestellte Defokussierung gekoppelt sein, muss es jedoch nicht. Dies ist unter anderem abhängig von der physikalischen Realisierung der Detektionseinheit. Es ist beispielsweise möglich, dass die Detektionseinheit insgesamt aus einer Vielzahl von Detektionskanälen aufgebaut ist. Dann kann beispielsweise in einem Normal-Betriebsmodus jedem Detektionskanal ein Detektionsbereich zugeordnet sein bzw. diesem entsprechen. Im Kontrast-Betriebsmodus hingegen werden mehrere Detektionskanäle zu einem Detektionsbereich zusammengefasst. Physikalisch wird dabei die Detektionseinheit als solche nicht verändert, lediglich die Zuordnung der Detektionskanäle zu einem Detektionsbereich ändert sich. Das Auswählen einer Anzahl von Detektionskanälen je Detektionsbereich erhöht die Flexibilität des erfindungsgemäßen Verfahrens. Je mehr Detektionskanäle, die winkel- und oder richtungssensitiv sind, pro Detektionsbereich verwendet werden, desto mehr winkel- und/ oder richtungssensitive Information lässt sich bei einer Bildgebung erhalten. In einem Extremfall können sämtliche verfügbaren Detektionskanäle zu einem Detektionsbereich zusammengefasst werden - die Bildgebung basiert dann aber auch nur noch auf einem einzigen Einzel-Teilchenstrahl und das Verfahren ist entsprechend langsamer. In den meisten praktischen Anwendungsfällen wird man dann deshalb einen erheblichen Anteil aller Einzel-Teilchenstrahlen, z.B. etwa ein Drittel, Viertel oder Fünftel aller verfügbaren Einzel-Teilchenstrahlen, zur Bildgebung verwenden und diese defokussiert auf den Detektor auftreffen lassen. In einem anderen Extremfall können alle verfügbaren Einzel-Teilchenstrahlen zur Bildgebung verwendet werden und treffen defokussiert auf den Detektor auf. Dann ist es allerdings erforderlich, eine entsprechend große Anzahl von Detektionskanälen vorzuhalten. Dieses Ausführungsbeispiel kann insbesondere bei kleinen Kontrastblenden und/ oder einem großen Pitch der ersten Einzel-Teilchenstrahlen besonders vorteilhaft sein.

Gemäß einer weiteren bevorzugten Ausführungsform der Erfindung umfasst das Verfahren des Weiteren im Kontrast-Betriebsmodus den folgenden Schritt:
Einstellen eines Pitches der zweiten Einzel-Teilchenstrahlen beim Auftreffen auf die Detektionseinheit basierend auf der ausgewählten Kontrastapertur und/oder der eingestellten Defokussierung und/oder der ausgewählten Anzahl der Detektionskanäle je Detektionsbereich. Der Pitch der zweiten Einzel-Teilchenstrahlen kann dabei beispielsweise so eingestellt werden, dass von vorhandenen Detektionskanälen möglichst wenige Detektionskanäle ungenutzt bleiben. Die Gesamtdetektionsfläche der Detektionseinheit wird dadurch möglichst optimal genutzt. Außerdem stellt das Einstellen des Pitches basierend auf der eingestellten Defokussierung sicher, dass unterschiedliche zweite Einzel-Teilchenstrahlen auf unterschiedliche Detektionsbereiche abgebildet werden. Werden Detektionskanäle nicht durch Zusammenschalten von beispielsweise Detektionspixeln erzeugt, sondern sind physikalisch separate und kleinste Detektionseinheiten, so geht das Einstellen eines Pitches automatisch mit der Auswahl einer Anzahl der Detektionskanäle einher. Es ist also möglich, dass die Parameter Anzahl der Detektionskanäle einerseits und Größe des Pitches andererseits nicht streng unabhängig voneinander sind. Gleichwohl können Lücken zwischen den defokussierten zweiten Einzel-Teilchenstrahlen vorhanden sein oder eingestellt werden und deshalb können vorhandene Detektionskanäle auch ungenutzt bleiben.

Außerdem kann die Gesamtausrichtung der defokussierten zweiten Einzel-Teilchenstrahlen auf die Detektionseinheit so vorgenommen werden, dass Mittelpunkte der Einzel-Teilchenstrahlen im Wesentlichen exakt auf einen Detektionskanal oder auch im Wesentlichen symmetrisch mittig zwischen Auftreffflächen von Detektionskanälen ausgerichtet sind. Letzteres ist beispielsweise bei einer Anzahl von drei Detektionskanälen je Detektionsbereich vorteilhaft, wobei die drei Detektionskanäle runde Auftreffflächen aufweisen können und "dreieckig" bzw. dicht möglichst zueinander angeordnet sein können. Auch andere Formen von Auftreffflächen sind möglich, zum Beispiel hexagonale Auftreffflächen.

Die Gesamtausrichtung der defokussierten zweiten Einzel-Strahlen kann beispielsweise mit einem Multistrahl-Ablenker im Sekundärpfad erfolgen, beispielsweise mittels des sog. Antiscans vor der Detektionseinheit. Es lassen sich so die zweiten Einzel-Teilchenstrahlen auf der Detektionseinheit parallel verschieben, bis die gewünschte Gesamtausrichtung der zweite Einzel-Teilchenstrahlen erreicht ist.

Der Pitch selbst kann über eine Einstellung der Vergrößerung im Primärpfad bzw. im Sekundärpfad eingestellt werden. Es ist auch möglich, bei der Erzeugung der Vielzahl von Einzel-Teilchenstrahlen im Primärpfad Multiaperturplatten mit verschiedenen Aperturanordnungen bzw. Aperturabständen einzusetzen.

Gemäß einer bevorzugten Ausführungsform der Erfindung weist das Verfahren im Kontrast-Betriebsmodus des Weiteren die folgenden Schritte auf:
Auswählen einer Anzahl von Einzel-Teilchenstrahlen, die in dem Kontrast-Betriebsmodus auf die Detektionseinheit auftreffen; und/oder
Ausblenden aller übrigen Einzel-Teilchenstrahlen.

Es ist möglich, dass nur ein einziger Einzel-Teilchenstrahl auf die Detektionseinheit auftreffen soll. In einem anderen Extremfall werden alle Einzel-Teilchenstrahlen ausgewählt, dann jedoch müssen entsprechend viele Detektionskanäle vorgehalten werden. Bevorzugt ist es aber so, dass zwei oder mehr Einzel-Teilchenstrahlen auf die Detektionseinheit auftreffen, beispielsweise etwa ein Drittel, ein Viertel oder ein Fünftel sämtlicher Einzel-Teilchenstrahlen. Eine Zielsetzung bei der Auswahl der Anzahl von Einzel-Teilchenstrahlen, die defokussiert auf den Detektor auftreffen, sollte es sein, dass möglichst viele der theoretisch vorhandenen Detektionskanäle auch zur Signalgewinnung verwendet werden. Sind nicht genug Detektionskanäle vorhanden bzw. ist die benötigte Fläche der Detektionseinheit nicht groß genug, so würden übrige bzw. überzählige Einzel-Teilchenstrahlen nicht mehr auf die Detektionseinheit bzw. auf Detektionskanäle auftreffen können. Dann kann es vorteilhaft sein, diese quasi überflüssigen Einzel-Teilchenstrahlen gezielt auszublenden. Das Ausblenden kann dabei im Primärpfad und/oder im Sekundärpfad erfolgen. Bevorzugt erfolgt es bereits im Primärpfad, zum Beispiel verhältnismäßig weit oben im teilchenoptischen Strahlengang kurz nach der Erzeugung der Vielzahl der Einzel-Teilchenstrahlen. Es kann im teilchenoptischen Strahlengang beispielsweise ein Strahl-Selektor vorgesehen sein. Zusätzlich oder alternativ ist es auch möglich, nicht für die defokussierte Detektion verwendete Einzel-Teilchenstrahlen mitzuführen und durch diese gezielt Aufladungseffekte an der Probe hervorzurufen.

Gemäß einer weiteren bevorzugten Ausführungsform der Erfindung weist das Verfahren des Weiteren den folgenden Schritt aufweist:
Ausrichten der defokussierten zweiten Einzel-Teilchenstrahlen beim Auftreffen auf die Detektionseinheit derart, dass die Hauptstrahlen der zweiten Einzel-Teilchenstrahlen im Wesentlichen exakt mittig auf einen Detektionskanal ausgerichtet werden; oder
Ausrichten der defokussierten zweiten Einzel-Teilchenstrahlen beim Auftreffen auf die Detektionseinheit derart, dass die Hauptstrahlen der zweiten Einzel-Teilchenstrahlen im Wesentlichen symmetrisch mittig zwischen Auftreffflächen von Detektionskanälen ausgerichtet werden.

Die mittige Ausrichtung auf einen Detektionskanal ist besonders zur Gewinnung von Winkelinformation geeignet, da diese Ausrichtung eine schalenartige Anordnung von Detektionskanälen erleichtert. Die symmetrische Ausrichtung mittig zwischen Auftreffflächen ist besonders vorteilhaft zur Gewinnung von Richtungsinformation. Das schließt aber jeweils nicht aus, auch zusätzlich Richtungsinformation oder zusätzlich Winkelinformation zu generieren.

Gemäß einer weiteren bevorzugten Ausführungsform der Erfindung umfasst diese im Kontrast-Betriebsmodus des Weiteren den folgenden Schritt:
Codieren der Einzelbilder in einem Falschfarbencode basierend auf Signalen aus den Detektionsbereichen und/oder den Detektionskanälen.

Es ist beispielsweise möglich, aufgrund der verwendeten Winkelinformation und/oder Richtungsinformation durch eine Farbcodierung steigende Kanten von fallenden Kanten zu unterscheiden. Es ist beispielsweise möglich, obere und untere Kanten oder linke und rechte Kanten in unterschiedlichen Farben als Falschfarbencode darzustellen. Dies erleichtert die Interpretation der gewonnenen Bilddaten.

Gemäß einer weiteren bevorzugten Ausführungsform der Erfindung weist das Verfahren im Kontrast-Betriebsmodus des Weiteren den folgenden Schritt auf:
Darstellen der Einzelbilder in einer perspektivischen Darstellung oder in einer 3D-Darstellung. Eine perspektivische Darstellung wird gelegentlich auch als 2,5D-Darstellung bezeichnet. Die perspektivische Darstellung ermöglicht mittels herkömmlicher 2D-Anzeigemittel einen guten räumlichen Eindruck des Dargestellten. Eine 3D-Darstellung kann beispielsweise mittels eines 3D-Displays wie beispielsweise mittels einer Datenbrille oder eines Displays der erweiterten Realität (engl. "augmented reality") oder der virtuellen Realität (engl. "virtual reality") erreicht werden, in dieser kann sich ein Benutzer bewegen bzw. seine Perspektive wechseln. Auch holografische Darstellungen sind möglich.

Gemäß einer weiteren bevorzugten Ausführungsform der Erfindung umfasst das Verfahren im Kontrast-Betriebsmodus des Weiteren den folgenden Schritt:
Bereitstellen einer Anordnung von Detektionskanälen, die richtungs-sensitiv und/oder radial sensitiv ist. Diese Anordnung von Detektionskanälen kann für jeden Detektionsbereich bereitgestellt werden. Dadurch ist es möglich, Richtungsinformation und/oder Winkelinformation der zweiten Einzel-Teilchenstrahlen beim Starten von der Objektebene bzw. dem Objekt bei der Detektion zu erhalten.

Gemäß einer weiteren bevorzugten Ausführungsform der Erfindung umfasst das Verfahren des Weiteren den folgenden Schritt:
Betreiben des Vielstrahl-Teilchenmikroskopes in einem Normal-Inspektionsmodus, umfassend die folgenden Schritte:
Bestrahlen des Objektes mit einer Vielzahl von geladenen ersten Einzel-Teilchenstrahlen, wobei jeder erste Einzel-Teilchenstrahl einen separaten Einzelfeldbereich des Objektes rasternd bestrahlt;
Aufsammeln von zweiten Einzel-Teilchenstrahlen, die aufgrund der ersten Einzel-Teilchenstrahlen aus dem Objekt austreten oder von diesem ausgehen;
fokussiertes Projizieren der zweiten Einzel-Teilchenstrahlen auf Detektionsbereiche einer Detektionseinheit derart, dass die von zwei verschiedenen Einzelfeldbereichen austretenden oder ausgehenden zweiten Einzel-Teilchenstrahlen auf verschiedene Detektionsbereiche projiziert werden, wobei jedem Detektionsbereich genau ein Detektionskanal zugeordnet ist; und
Erzeugen von Einzelbildern von jedem der Einzelfeldbereiche basierend auf Daten, die mittels Signalen aus jedem der Detektionsbereiche mit ihrem jeweils zugeordneten Detektionskanal gewonnen werden oder gewonnen worden sind.

Das Betreiben des Vielstrahl-Teilchenmikroskopes in einem Normal-Inspektionsmodus beschreibt also im Prinzip das Betreiben eines Vielstrahl-Teilchenmikroskopes wie bereits aus dem Stand der Technik bekannt. Wichtig ist dabei das herkömmliche fokussierte Projizieren der zweiten Einzel-Teilchenstrahlen auf die Detektionseinheit. Dabei kann die Detektionseinheit, die im Kontrast-Betriebsmodus verwendet wird, dieselbe sein, die auch im Normal-Inspektionsmodus verwendet wird. Dann ist aber die Größe und Lage der Detektionsbereiche eine andere und es erfolgt eine andere Zuordnung von Detektionsbereichen zu Detektionskanälen, im Normal-Inspektionsmodus wird jeder Detektionsbereich lediglich einem einzelnen Detektionskanal zugeordnet.

Gemäß einer bevorzugten Ausführungsform der Erfindung wird zwischen einem Betreiben des Vielstrahl-Teilchenmikroskops im Kontrast-Betriebsmodus und im Normal-Inspektionsmodus gewechselt. Dabei ist es möglich, dass zwischen den beiden Modi streng alterniert wird. Es ist aber auch möglich, dass beispielsweise zunächst im Normal-Inspektionsmodus ein größerer Probenbereich abgescannt wird und dass anschließend mehrere Teilbereiche der Probe im Kontrast-Betriebsmodus abgescannt werden. Dadurch können im Kontrast-Betriebsmodus besonders interessante Probenbereiche noch einmal genauer untersucht werden.

Gemäß einer weiteren bevorzugten Ausführungsform der Erfindung sind in einer Steuerung des Vielstrahl-Teilchenmikroskops verschiedene Kontrast-Betriebsmodi mit zugehörigen Betriebsparametern hinterlegt und das Verfahren weist des Weiteren den folgenden Schritt auf:
Auswählen eines Kontrast-Betriebsmodus und Betreiben des Vielstrahl-Teilchenmikroskops in diesem Kontrast-Betriebsmodus. Die verschiedenen Kontrast-Betriebsmodi können sich beispielsweise durch die verwendeten Kontrastaperturen, die eingestellte Defokussierung, die Anzahl der auf den Detektor auftreffenden bzw. im Kontrast-Betriebsmodus zur Bildgebung verwendeten zweiten Einzel-Teilchenstrahlen, die Anzahl von Detektionskanälen je Detektionsbereich bzw. je zweitem Einzel-Teilchenstrahl, die Strahlstromstärke der Einzel-Teilchenstrahlen, die Landeenergie, den Strahlpitch, das Probenmaterial etc. unterscheiden. Zu den auswählbaren Kontrast-Betriebsmodi können dann auch anwendungsbezogen die folgenden Modi zählen: Kantenkontrast-Betriebsmodus, Materialkontrast-Betriebsmodus, Aufladungskontrast-Betriebsmodus sowie Richtungs-Kantenkontrast-Betriebsmodus. Anders als im herkömmlichen Kantenkontrast-Betriebsmodus, der nur das Vorhandensein einer Kante analysiert, ist es mit dem Richtungs-Kantenkontrast-Betriebsmodus möglich, zwischen verschiedenen Kantenarten hinsichtlich ihrer Natur zu unterscheiden (steigende Flanke, fallende Flanke, linke Seite, rechte Seite etc.). Dazu bedarf es neben der Winkelinformation auch der Richtungsinformation und somit der richtungs-sensitiven Detektion der zweiten Einzel-Teilchenstrahlen im Kontrast-Betriebsmodus.

Die oben beschriebenen Ausführungsformen der Erfindung können ganz oder teilweise miteinander kombiniert werden, sofern sich dadurch keine technischen Widersprüche ergeben.

Gemäß einem zweiten Aspekt der Erfindung bezieht sich diese auf ein Vielstrahl-Teilchenmikroskop, das Folgendes aufweist:
eine Vielstrahl-Teilchenquelle, welche konfiguriert ist, um ein erstes Feld einer Vielzahl von geladenen ersten Einzel-Teilchenstrahlen zu erzeugen;
eine erste Teilchenoptik mit einem ersten teilchenoptischen Strahlengang, die konfiguriert ist, um die erzeugten ersten Einzel-Teilchenstrahlen auf eine Objektebene abzubilden, so dass die ersten Einzel-Teilchenstrahlen an Auftrefforten auf ein Objekt treffen, die ein zweites Feld bilden;
ein Detektionssystem mit einer Vielzahl von Detektionsbereichen, die ein drittes Feld bilden;
eine zweite Teilchenoptik mit einem zweiten teilchenoptischen Strahlengang, die konfiguriert ist, um zweite Einzel-Teilchenstrahlen, die von den Auftrefforten im zweiten Feld ausgehen, auf das dritte Feld der Detektionsbereiche des Detektionssystems abzubilden;
eine magnetische Objektivlinse, durch die sowohl die ersten als auch die zweiten Einzel-Teilchenstrahlen hindurchtreten;
eine Strahlweiche, die in dem ersten teilchenoptischen Strahlengang zwischen der Vielstrahl-Teilchenquelle und der Objektivlinse angeordnet ist, und die im zweiten teilchenoptischen Strahlengang zwischen der Objektivlinse und dem Detektionssystem angeordnet ist;
eine Modus-Auswahleinrichtung, die eingerichtet ist, eine Auswahl zwischen einem Normal-Betriebsmodus und einem Kontrast-Betriebsmodus zu treffen; und
eine Steuerung;
wobei in dem zweiten teilchenoptischen Strahlengang zwischen der Strahlweiche und dem Detektionssystem eine Strahlüberkreuzung der zweiten Einzel-Teilchenstrahlen angeordnet ist,
wobei im Bereich der Strahlüberkreuzung eine Kontrastblende zum Filtern der zweiten Einzel-Teilchenstrahlen nach ihren Startwinkeln von der Objektebene angeordnet ist,
wobei die Steuerung konfiguriert ist, die zweite Teilchenoptik in dem Normal-Betriebsmodus derart anzusteuern, dass die zweiten Einzel-Teilchenstrahlen im Wesentlichen fokussiert auf die Detektionsbereiche auftreffen, wobei in dem Normal-Betriebsmodus jedem Detektionsbereich genau ein Detektionskanal zur Signalauswertung zugeordnet ist, und
wobei die Steuerung konfiguriert ist, die zweite Teilchenoptik in dem Kontrast-Betriebsmodus derart anzusteuern, dass zumindest einer oder einige oder alle der zweiten Einzel-Teilchenstrahlen defokussiert auf die Detektionsbereiche auftreffen, wobei in dem Kontrast-Betriebsmodus jedem Detektionsbereich eine Mehrzahl von Detektionskanälen zur Signalauswertung zugeordnet ist, wobei bei dem defokussierenden Auftreffen der zweiten Einzel-Teilchenstrahlen auf die Detektionsbereiche der Detektionseinheit ein Übersprechen der zweiten Einzel-Teilchenstrahlen vermieden wird, und
wobei die Mehrzahl der Detektionskanäle jeweils so angeordnet ist, dass eine winkelabhängige und/ oder richtungsabhängige Detektion von zweiten Einzel-Teilchenstrahlen in dem Kontrast-Betriebsmodus erfolgen kann.

Das erfindungsgemäße Vielstrahl-Teilchenmikroskop ist insbesondere zur Durchführung des beschriebenen erfindungsgemäßen Verfahrens gemäß dem ersten Aspekt der Erfindung geeignet. Die zur Beschreibung des Vielstrahl-Teilchenmikroskops verwendeten Begriffe entsprechen dabei jenen zur Beschreibung des erfindungsgemäßen Verfahrens.

Gemäß einer bevorzugten Ausführungsform der Erfindung weist das Detektionssystem einen oder mehrere Teilchendetektoren auf oder das Detektionssystem besteht aus einem oder mehreren Teilchendetektoren. Gemäß einer bevorzugten Ausführungsform weist das Detektionssystem einen oder mehrere Teilchendetektoren sowie mehrere diesem oder diesen nachgeschaltete Lichtdetektoren auf. Beispielsweise kann das Detektionssystem als Teilchendetektor eine Szintillator-Platte mit mehreren Detektionsbereichen und/oder Detektionskanälen aufweisen. Das Projizieren der Wechselwirkungsprodukte auf die Detektionsbereiche/Detektionskanäle des Teilchendetektors erfolgt dabei mithilfe einer geeigneten Teilchenoptik, beispielsweise mittels eines Projektionslinsensystems und einem kollektiven Scan-Ablenker (sog. Anti-Scan). Die von dem Teilchendetektor ausgesendeten Lichtsignale gelangen dann in geeigneter Weise zu einem dem jeweiligen Detektionsbereich bzw. Detektionskanal des Teilchendetektors zugeordneten Lichtdetektor. Es ist zum Beispiel möglich, das von einem Detektionsbereich des Teilchendetektors ausgesendete Licht über eine entsprechende Lichtoptik in Glasfasern einzukoppeln, die wiederum mit dem eigentlichen Lichtdetektor verbunden sind. Der Lichtdetektor umfasst beispielsweise einen Fotomultiplier, eine Fotodiode, eine Avalanche-Fotodiode oder andere Arten geeigneter Lichtdetektoren. Es ist beispielsweise möglich, dass ein Detektionsbereich mit einer ihm zugeordneten Glasfaser und wiederum mit einem dieser Glasfaser zugeordneten Lichtdetektor einen Detektionskanal (im Signalsinne) bildet. Alternativ ist es möglich, dass ein Lichtdetektor keine Glasfaser aufweist. Es ist beispielsweise möglich, anstelle eines Glasfaserbündels ein Array aus lichtsensitiven Detektoren (z.B. Fotomultiplier, Fotodioden, Avalanche-Fotodioden etc.) direkt als Signaleintrittsoberfläche vorzusehen. Dabei wird sozusagen jede Glasfaser durch einen oder mehrere Lichtdetektorpixel ersetzt.

Gemäß einer alternativen Ausführungsform der Erfindung besteht das Detektionssystem aus einem oder mehreren Teilchendetektoren. Das Detektionssystem weist dann also einen oder mehrere Teilchendetektoren auf, aber keine Lichtdetektoren. Es ist dann möglich, die sekundären Einzel-Teilchenstrahlen direkt zu detektieren, ohne den Umweg über Photonen, zum Beispiel indem man sie in die Sperrschicht eines Halbleiters injiziert, wodurch dann wieder eine Elektronenlawine ausgelöst werden kann. Hierfür wird dann ein entsprechend strukturierter Halbleiterdetektor benötigt, der für jeden Strahl mindestens eine unabhängige Konversionseinheit aufweist.

Gemäß einer bevorzugten Ausführungsform der Erfindung weist jeder Detektionskanal genau eine Glasfaser auf und verschiedene Detektionskanäle weisen verschiedene Glasfasern auf. Es liegt hier also eine eineindeutige Zuordnung vor. Zwar gibt es im Stand der Technik auch Glasfasern, die mehrkanalig sind und verschiedene Signale beispielsweise durch einen sektoriellen Aufbau der Glasfaser separat übertragen. Allerdings stellt hier das ungewollte Mischen/ Modenkopplung verschiedener Kanäle aktuell noch eine Herausforderung dar, es kann aber beispielsweise ein teilweises oder graduelles Mischen zwischen Detektionskanälen, die demselben Detektionsbereich zuzuordnen sind, akzeptabel sein.

Durch die oben schon beschriebene Zuordnung von Detektionsbereichen eines Teilchendetektors zu bestimmten Detektionskanälen bzw. Lichtdetektoren und konkret zur Signaleintrittsoberfläche von Glasfaserbündeln bekommt auch die geometrische Ausgestaltung der Signaleintrittsoberfläche eine weitergehende Bedeutung. Es ist wichtig, in welcher Weise die Glasfasern zueinander angeordnet bzw. gepackt sind. Für eine gute Auflösung ist es vorteilhaft, die Glasfasern mit ihren jeweiligen Signaleintrittsoberflächen möglichst dicht aneinander zu packen.

Gemäß einer bevorzugten Ausführungsform der Erfindung weist jeder Detektionskanal eine Signaleintrittsoberfläche auf, die kreisförmig oder dreieckig oder hexagonal ist. Im dreieckigen Fall handelt es sich bevorzugt um ein gleichschenkliges oder höchst bevorzugt um ein gleichseitiges Dreieck. Bei der Signaleintrittsoberfläche kann es sich um die Auftrefffläche auf einem Teilchendetektor oder aber um eine Auftrefffläche von Photonen auf eine Glasfaser handeln. Bei einem Detektionssystem, das einen oder mehrere Teilchendetektoren sowie mehrere diesem oder diesen nachgeschaltete Lichtdetektoren aufweist, hat also jeder Kanal gegebenenfalls zwei Signaleintrittsoberflächen, nämlich einmal bei der Teilchendetektion und später auch noch einmal bei der Lichtdetektion. Für mindestens eine Signaleintrittsoberfläche ist das Kriterium kreisförmig oder dreieckig gemäß dieser Ausführungsvariante erfüllt, bevorzugt ist es bei der Lichtdetektion erfüllt.

Gemäß einer bevorzugten Ausführungsform der Erfindung weisen die Signaleintrittsoberflächen der Detektionskanäle eine hexagonal dichteste Anordnung auf und/oder die Signaleintrittsoberflächen sind insgesamt als Hexagon angeordnet. Diese hexagonal dichteste Anordnung bzw. die Anordnung insgesamt als Hexagon lässt sich insbesondere mit der oben beschriebenen kreisförmigen oder dreieckigen oder hexagonalen Signaleintrittsoberfläche der Detektionskanäle erreichen. Es ist aber auch möglich, dass die Signaleintrittsoberflächen der Detektionskanäle rechteckig oder quadratisch sind und dass die Signaleintrittsoberflächen insgesamt ein Rechteck oder Quadrat ergeben. Auch andere geometrische Formen sind denkbar, allerdings steigt dann der Aufwand bei der Signalauswertung.

Gemäß einer bevorzugten Ausführungsform der Erfindung sind im Kontrast-Betriebsmodus einem Detektionsbereich genau drei oder genau vier oder genau sechs Detektionskanäle zugeordnet. Im Falle von genau drei Detektionskanälen kann die Signaleintrittsoberfläche jedes Detektionskanals beispielsweise kreisförmig oder hexagonal sein und die drei Detektionskanäle sind "dreieckig" und dicht gepackt zueinander angeordnet. Durch diese Anordnung ist eine richtungssensitive Detektion für jeden Detektionskanal möglich. Sind genau vier Detektionskanäle einem Detektionsbereich zugeordnet, kann dies beispielsweise durch vier kongruente gleichschenklige Dreiecke mit rechtem Winkel, die insgesamt als Quadrat angeordnet sind, realisiert sein. Die Ecken der Dreiecke stoßen also im Mittelpunkt des Quadrates aufeinander. Auch bei dieser Ausführungsform ist eine Richtungssensitivität durch die vier Sektoren einfach möglich. Umfasst ein Detektionsbereich genau sechs Detektionskanäle, so können diese sechs Detektionskanäle beispielsweise durch sechs insgesamt als Hexagon angeordnete gleichseitige Dreiecke realisiert sein. Auch diese Ausführungsvariante gewährleistet die Richtungssensitivität. Es ist aber natürlich auch möglich, andere Anordnungsformen zu wählen, beispielsweise genau vier Detektionskanäle, deren Signaleintrittsoberflächen jeweils als Quadrate ausgebildet sind, wobei die vier Detektionskanäle dann insgesamt ebenfalls als Quadrat angeordnet sind.

Gemäß einer bevorzugten Ausführungsform der Erfindung sind im Kontrast-Betriebsmodus einem Detektionsbereich mindestens zwei Schalen einer konzentrischen schalenartigen Anordnung von Signaleintrittsoberflächen zugeordnet. Diese schalenartige konzentrische Anordnung von Signaleintrittsoberflächen ermöglicht das Gewinnen von radialsensitiver Information bzw. Winkelinformation, bevorzugt zusätzlich zur Gewinnung von richtungssensitiver Information. Die innere Schale beinhaltet dabei Information über einen zentralen Winkelbereich und damit einen relativ steilen Einfall von Strahlen auf den Detektor, die zweite Schale umfasst größere Winkelabweichungen und mithin einen flacheren Einfall der Strahlen auf die Detektionsfläche. Es ist möglich, genau zwei Schalen vorzusehen, es ist aber auch möglich, mehr als zwei Schalen vorzusehen.

Gemäß einer bevorzugten Ausführungsform der Erfindung ist die Anordnung der Signaleintrittsoberflächen der Detektionskanäle hexagonal und die innerste Schale umfasst genau einen, genau sieben oder genau neunzehn Detektionskanäle. In diesem Fall sind die einzelnen Signaleintrittsoberflächen der Detektionskanäle beispielsweise kreisförmig oder hexagonal und die innerste Schale umfasst beispielsweise einen zentralen Detektionskanal und sechs darum kreisringförmig bzw. hexagonal angeordnete weitere Detektionskanäle, bzw. im Falle von insgesamt neunzehn Detektionskanälen sind um die beschriebenen 1 + 6 = 7 Detektionskanäle noch einmal zwölf weitere Detektionskanäle angeordnet.

Gemäß einer weiteren bevorzugten Ausführungsform der Erfindung ist die Anordnung der Signaleintrittsoberflächen der Detektionskanäle hexagonal und die innerste Schale umfasst genau sechs oder genau 24 Detektionskanäle. Die Signaleintrittsoberflächen sind dann beispielsweise in Form von gleichseitigen Dreiecken ausgebildet. Im Falle von genau sechs Detektionskanälen als innerste Schale haben diese sechs dreieckigen Signaleintrittsoberflächen dann die sechs-zählige Rotationssymmetrie um den Mittelpunkt, der durch eine Ecke der Dreiecke gebildet wird. Im Falle von genau 24 Detektionskanälen wird aus der beschriebenen hexagonalen Sechsereinheit ein größeres Hexagon mit insgesamt 24 Detektionskanälen aufgebaut.

Gemäß einer weiteren bevorzugten Ausführungsform der Erfindung ist die Anordnung der Signaleintrittsoberflächen der Detektionskanäle rechteckig und die innerste Schale umfasst genau einen, genau neun oder genau sechzehn Detektionskanäle. Im Falle von genau neun Detektionskanälen sind beispielsweise neun Rechtecke oder Quadrate so zueinander angeordnet, dass sie wiederum ein Rechteck bzw. Quadrat ergeben. Im Falle von genau sechzehn Detektionskanälen sind um das Neunerrechteck bzw. Neunerquadrat noch einmal zusätzlich sieben Detektionskanäle angeordnet, so dass sich ein größeres Rechteck bzw. Quadrat ergibt.

Es ist auch möglich, dass Gruppen von Detektionskanälen miteinander verbunden sind, zum Beispiel laserverschweißt miteinander. Dies trägt dazu bei, einen Signalverlust zu minimieren, der durch ein Auftreffen von Sekundärteilchen zwischen Detektionskanälen ansonsten resultieren würde. Ein Verbinden bzw. insbesondere Laserverschweißen ist insbesondere dann möglich, wenn die verbundenen oder laserverschweißten Detektionskanäle jeweils demselben Detektionsbereich zuzuordnen sind. Ein durch die Verbindung möglicherweise auftretendes Übersprechen zwischen den Detektionskanälen ist dann weniger oder gar nicht störend.

Dem Fachmann werden sich weitere geometrische Ausgestaltungen erschließen, die für die praktische Anwendung vorteilhaft sind.

Die beschriebenen Ausführungsformen gemäß dem zweiten Aspekt der Erfindung können ganz oder teilweise miteinander kombiniert werden, sofern hierdurch keine technischen Widersprüche resultieren.

Gemäß einem dritten Aspekt der Erfindung bezieht sich diese auf ein Computerprgrammprodukt mit einem Programmcode, umfassend Befehle, die bewirken, dass die Vorrichtung gemäß dem nachstehenden Anspruch 13 die Verfahrensschritte des nachstehenden Anspruchs 1 ausführt.

Es ist auch möglich, die Ausführungsformen gemäß dem ersten, dem zweiten und/oder dem dritten Aspekt der Erfindung ganz oder teilweise miteinander zu kombinieren, sofern hierdurch keine technischen Widersprüche resultieren.

Die Erfindung wird noch besser verstanden werden unter Bezugnahme auf die beigefügten Figuren. Dabei zeigen:
- Fig. 1:: zeigt ein Mehrstrahl-Teilchenmikroskop in schematischer Darstellung (MSEM);
- Fig. 2a:: zeigt schematisch ein Detektionssystem eines Vielstrahl-Teilchenmikroskopes;
- Fig. 2b:: zeigt eine alternative Ausführungsvariante eines Detektionssystems;
- Fig. 3:: vergleicht schematisch die Auswirkung einer Winkelverteilung von zweiten Einzel-Teilchenstrahlen bei fokussierter und defokussierter Detektion;
- Fig. 4:: illustriert ein Anwendungsbeispiel für die Erfindung (Kantenkontrast);
- Fig. 5:: illustriert ein Anwendungsbeispiel für die Erfindung (Spannungskontrast);
- Fig. 6:: zeigt schematisch eine Detektion fokussierter Sekundärstrahlen in einem Normal-Inspektionsmodus;
- Fig. 7:: zeigt schematisch eine Detektion defokussierter Sekundärstrahlen in einem Kontrast-Betriebsmodus;
- Fig. 8:: zeigt schematisch eine Detektion defokussierter Sekundärstrahlen mit drei Detektionskanälen je Detektionsbereich;
- Fig. 9:: zeigt schematisch eine Detektion defokussierter Sekundärstrahlen mit sieben Detektionskanälen je Detektionsbereich;
- Fig. 10:: illustriert schematisch verschiedene Geometrien von Detektionsbereichen und Detektionskanälen;
- Fig. 11:: illustriert schematisch eine Geometrie von Detektionsbereichen und Detektionskanälen;
- Fig. 12:: illustriert schematisch verschiedene Geometrien von Detektionsbereichen und Detektionskanälen;
- Fig. 13:: illustriert schematisch eine Geometrie von Detektionsbereichen und Detektionskanälen;
- Fig. 14: zeigt schematisch weitere Ausführungsvarianten für Detektionsberieche und Detektionskanäle; und
- Fig. 15: zeigt einen beispielhaften Workflow, bei dem das erfindungsgemäße Verfahren eingesetzt wird.

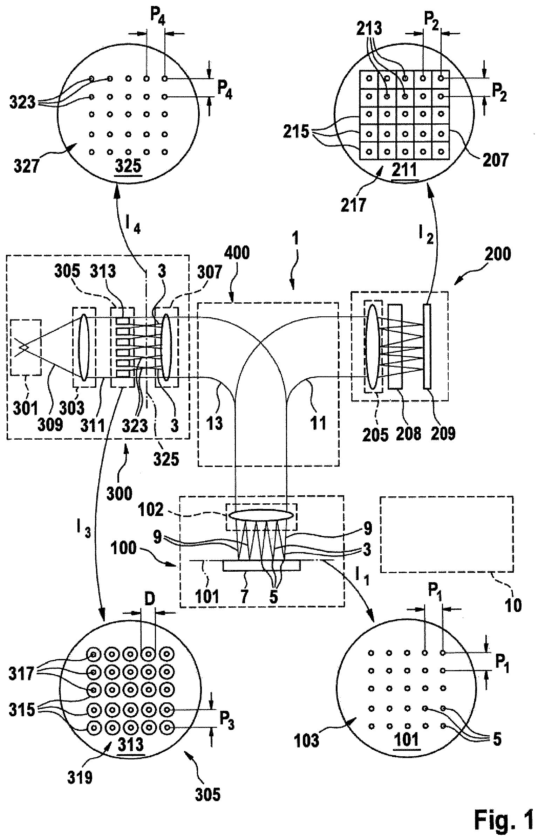

Fig. 1 ist eine schematische Darstellung eines Teilchenstrahlsystems 1 in Form eines Mehrstrahl-Teilchenmikroskops 1, welches eine Vielzahl von Teilchenstrahlen einsetzt. Das Teilchenstrahlsystem 1 erzeugt eine Vielzahl von Teilchenstrahlen, welche auf ein zu untersuchendes Objekt treffen, um dort Wechselwirkungsprodukte, bspw. Sekundärelektronen, zu generieren, welche von dem Objekt ausgehen und nachfolgend detektiert werden. Das Teilchenstrahlsystem 1 ist vom Rasterelektronenmikroskop-Typ ("scanning electron microscope", SEM), welches mehrere primäre Teilchenstrahlen 3 einsetzt, die an mehreren Orten 5 auf eine Oberfläche des Objekts 7 auftreffen und dort mehrere räumlich voneinander getrennte Elektronenstrahlflecken oder Spots erzeugen. Das zu untersuchende Objekt 7 kann von einer beliebigen Art sein, bspw. ein Halbleiterwafer oder eine biologische Probe, und eine Anordnung miniaturisierter Elemente oder dergleichen umfassen. Die Oberfläche des Objekts 7 ist in einer ersten Ebene 101 (Objektebene) einer Objektivlinse 102 eines Objektivlinsensystems 100 angeordnet.

Der vergrößerte Ausschnitt I1 der Fig. 1 zeigt eine Draufsicht auf die Objektebene 101 mit einem regelmäßigen rechtwinkligen Feld 103 von Auftrefforten 5, welche in der ersten Ebene 101 gebildet werden. In Fig. 1 beträgt die Zahl der Auftrefforte 25, welche ein 5 x 5-Feld 103 bilden. Die Zahl 25 an Auftrefforten ist eine aus Gründen der vereinfachten Darstellung gewählte Zahl. In der Praxis kann die Zahl an Strahlen, und damit die Zahl der Auftrefforte, wesentlich größer gewählt werden, wie bspw. 20 x 30, 100 x 100 und dergleichen.

In der dargestellten Ausführungsform ist das Feld 103 von Auftrefforten 5 ein im Wesentlichen regelmäßiges rechtwinkliges Feld mit einem konstanten Abstand P1 zwischen benachbarten Auftrefforten. Beispielhafte Werte des Abstands P1 sind 1 Mikrometer, 10 Mikrometer und 40 Mikrometer. Es ist jedoch auch möglich, dass das Feld 103 andere Symmetrien aufweist, wie bspw. eine hexagonale Symmetrie.

Ein Durchmesser der in der ersten Ebene 101 geformten Strahlflecken kann klein sein. Beispielhafte Werte dieses Durchmessers betragen 1 Nanometer, 5 Nanometer, 10 Nanometer, 100 Nanometer und 200 Nanometer. Das Fokussieren der Partikelstrahlen 3 zur Formung der Strahlflecken 5 erfolgt durch das Objektivlinsensystem 100.

Die auf das Objekt treffenden Primärteilchen generieren Wechselwirkungsprodukte bspw. Sekundärelektronen, Rückstreuelektronen oder Primärteilchen, die aus anderweitigen Gründen eine Bewegungsumkehr erfahren haben, welche von der Oberfläche des Objekts 7 oder von der ersten Ebene 101 ausgehen. Die von der Oberfläche des Objekts 7 ausgehenden Wechselwirkungsprodukte werden durch die Objektivlinse 102 zu sekundären Teilchenstrahlen 9 geformt. Das Teilchenstrahlsystem 1 stellt einen Teilchenstrahlengang 11 bereit, um die Vielzahl sekundärer Teilchenstrahlen 9 einem Detektorsystem 200 zuzuführen. Das Detektorsystem 200 umfasst eine Teilchenoptik mit einer Projektionslinse 205, um die sekundären Teilchenstrahlen 9 auf einen Teilchen-Multi-Detektor 209 zu richten.

Der Ausschnitt I2 in Fig. 1 zeigt eine Draufsicht auf die Ebene 211, in welcher einzelne Detektionsbereiche des Teilchen-Multi-Detektors 209 liegen, auf welche die sekundären Teilchenstrahlen 9 an Orten 213 auftreffen. Die Auftrefforte 213 liegen in einem Feld 217 mit einem regelmäßigen Abstand P2 zueinander. Beispielhafte Werte des Abstands P2 sind 10 Mikrometer, 100 Mikrometer und 200 Mikrometer.

Die primären Teilchenstrahlen 3 werden in einer Strahlerzeugungsvorrichtung 300 erzeugt, welche wenigstens eine Teilchenquelle 301 (z.B. eine Elektronenquelle), wenigstens eine Kollimationslinse 303, eine Multiaperturanordnung 305 und eine Feldlinse 307 umfasst. Die Teilchenquelle 301 erzeugt einen divergierenden Teilchenstrahl 309, welcher durch die Kollimationslinse 303 kollimiert oder zumindest weitgehend kollimiert wird, um einen Strahl 311 zu formen, welcher die Multiaperturanordnung 305 beleuchtet.

Der Ausschnitt I3 in Fig. 1 zeigt eine Draufsicht auf die Multiaperturanordnung 305. Die Multiaperturanordnung 305 umfasst eine Multiaperturplatte 313 welche eine Mehrzahl von darin ausgebildeten Öffnungen bzw. Aperturen 315 aufweist. Mittelpunkte 317 der Öffnungen 315 sind in einem Feld 319 angeordnet, welches auf das Feld 103 abgebildet wird, welches durch die Strahlflecken 5 in der Objektebene 101 gebildet wird. Ein Abstand P3 der Mittelpunkte 317 der Aperturen 315 voneinander kann beispielhafte Werte von 5 Mikrometer, 100 Mikrometer und 200 Mikrometer aufweisen. Die Durchmesser D der Aperturen 315 sind kleiner als der Abstand P3 der Mittelpunkte der Aperturen. Beispielhafte Werte der Durchmesser D sind 0,2 x P3, 0,4 x P3 und 0,8 x P3.

Teilchen des beleuchtenden Teilchenstrahles 311 durchsetzen die Aperturen 315 und bilden Teilchenstrahlen 3. Teilchen des beleuchtenden Strahles 311, welche auf die Platte 313 treffen, werden durch diese abgefangen und tragen nicht zur Bildung der Teilchenstrahlen 3 bei.

Die Multiaperturanordnung 305 fokussiert aufgrund eines angelegten elektrostatischen Felds jeden der Teilchenstrahlen 3 derart, dass in einer Ebene 325 Strahlfoki 323 gebildet werden. Alternativ können die Strahlfoki 323 virtuell sein. Ein Durchmesser der Strahlfoki 323 kann bspw. 10 Nanometer, 100 Nanometer und 1 Mikrometer betragen.

Die Feldlinse 307 und die Objektivlinse 102 stellen eine erste abbildende Teilchenoptik bereit, um die Ebene 325, in der die Strahlfoki 323 gebildet werden, auf die erste Ebene 101 abzubilden, so dass dort ein Feld 103 von Auftrefforten 5 bzw. Strahlflecken entsteht. Soweit in der ersten Ebene eine Oberfläche des Objekts 7 angeordnet ist, werden die Strahlflecken entsprechend auf der Objektoberfläche gebildet.

Die Objektivlinse 102 und die Projektionslinsenanordnung 205 stellen eine zweite abbildende Teilchenoptik bereit, um die erste Ebene 101 auf die Detektionsebene 211 abzubilden. Die Objektivlinse 102 ist somit eine Linse, welche sowohl Teil der ersten als auch der zweiten Teilchenoptik ist, während die Feldlinse 307 nur der ersten Teilchenoptik und die Projektionslinse 205 nur der zweiten Teilchenoptik angehören.

Eine Strahlweiche 400 ist in dem Strahlengang der ersten Teilchenoptik zwischen der Multiaperturanordnung 305 und dem Objektivlinsensystem 100 angeordnet. Die Strahlweiche 400 ist auch Teil der zweiten Optik im Strahlengang zwischen dem Objektivlinsensystem 100 und dem Detektorsystem 200.

Weitergehende Informationen zu solchen Vielstrahl-Teilchenstrahlsystemen und darin eingesetzten Komponenten, wie etwa Teilchenquellen, Multiaperturplatte und Linsen, kann aus den internationalen Patentanmeldungen WO 2005 / 024881 A2, WO 2007 / 028595 A2, WO 2007 / 028596 A1, WO 2011 / 124352 A1 und WO 2007 / 060017 A2 und den deutschen Patentanmeldungen DE 10 2013 016 113 A1 und DE 10 2013 014 976 A1 erhalten werden.

Das Vielzahl-Teilchenstrahlsystem weist weiterhin ein Computersystem 10 auf, das sowohl zur Steuerung der einzelnen teilchenoptischen Komponenten des Vielzahl-Teilchenstrahlsystems ausgebildet ist, als auch zur Auswertung und Analyse der mit dem Multi-Detektor 209 bzw. der Detektionseinheit 209 gewonnenen Signale. Es kann auch zum Durchführen des erfindungsgemäßen Verfahrens verwendet werden. Das Computersystem 10 kann aus mehreren Einzelcomputern oder Komponenten aufgebaut sein.

In der Darstellung gemäß Fig. 1 treffen die zweiten Einzel-Teilchenstrahlen 9 fokussiert auf die Detektionsebene 211. Diese Darstellung bzw. diese Betriebsart entspricht dem bereits bekannten Betrieb eines Vielstrahl-Teilchenmikroskops in einem Normal-Betriebsmodus bzw. in einem Normal-Inspektionsmodus. Bei einem Betrieb des Vielstrahlteilchenmikroskops gemäß dem erfindungsgemäßen Verfahren, das ein Betreiben des Mikroskops in einem Kontrast-Betriebsmodus umfasst, ändert sich der Einfall der zweiten Einzel-Teilchenstrahlen auf die Detektionsebene 211, der Einfall erfolgt im Kontrast-Betriebsmodus defokussiert. Darauf wird im Folgenden noch näher eingegangen werden.

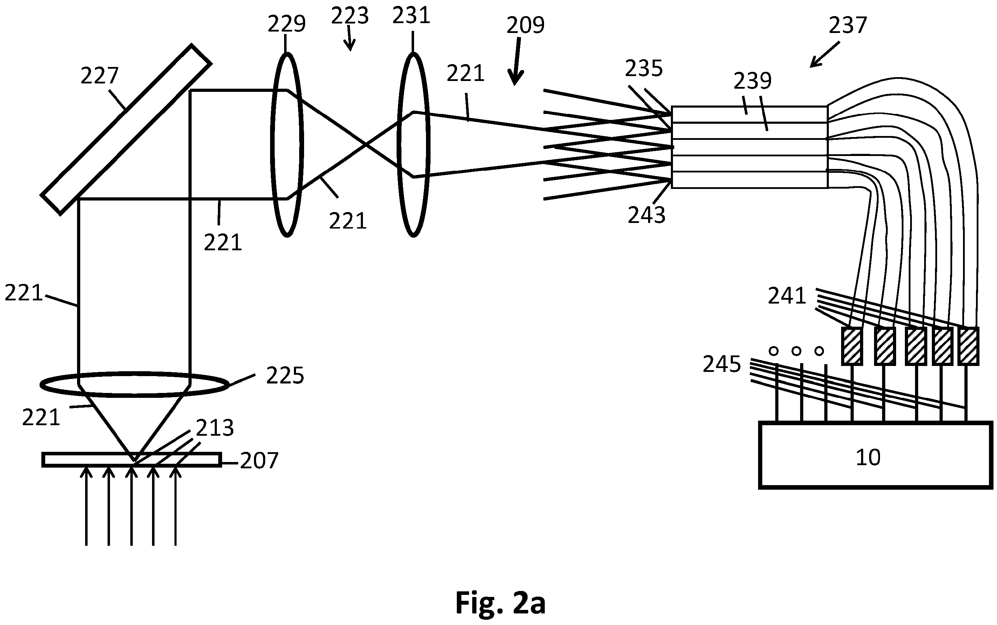

Fig. 2a ist eine schematische Darstellung, um beispielshaft eine Realisierung des Detektors 209 zu verdeutlichen, Bezug genommen wird zunächst wieder auf den Normal-Betriebsmodus. Der Detektor 209 umfasst dabei als Teilchendetektor eine Szintillator-Platte 207, auf welche die Wechselwirkungsprodukte, beispielsweise Sekundärelektronenstrahlen, durch eine Elektronenoptik gerichtet werden. Diese Elektronenoptik umfasst, wenn sie in das Vielstrahl-Teilchenmikroskop der Fig. 1 integriert ist, die elektronenoptischen Komponenten der Teilchenoptik, welche die Elektronenstrahlen 9 formen, d.h. bspw. die Objektivlinse 102, welche die Elektronenstrahlen 9 hin zu dem Detektor 209 leiten, wie bspw. die Strahlweiche 400, und welche die Elektronenstrahlen 9 auf der Oberfläche der Szintillator-Platte 207 fokussieren, wie bspw. die Linse 205. Die Elektronenstrahlen 9 treffen an Auftrefforten 213 auf die Szintillator-Platte 207 auf. Auch wenn die Elektronenstrahlen 9 auf der Oberfläche der Szintillator-Platte 207 fokussiert werden, werden auf der Oberfläche Strahlflecken gebildet, deren Durchmesser nicht beliebig klein sind. Die Mittelpunkte der Strahlflecken können als die Auftrefforte 213 betrachtet werden, welche mit dem Abstand P₂ (vgl. Fig. 1) voneinander angeordnet sind.

Die Szintillator-Platte 207 enthält ein Szintillator-Material, welches durch die auftreffenden Elektronen der Elektronenstrahlen 9 dazu angeregt wird, Photonen auszusenden. Jeder der Auftrefforte 213 bildet somit eine Quelle für Photonen. In Fig. 2a ist lediglich ein einziger entsprechender Strahlengang 221 dargestellt, welcher von dem Auftreffort 213 des mittleren der fünf dargestellten Elektronenstrahlen 9 ausgeht. Der Strahlengang 221 verläuft durch eine Lichtoptik 223, welche im gezeigten Beispiel eine erste Linse 225, einen Spiegel 227, eine zweite Linse 229 und eine dritte Linse 231 umfasst, und trifft dann auf eine Lichtempfangsfläche 235 (Signaleintrittsoberfläche 235) eines Lichtdetektionssystems 237. Die Lichtempfangsfläche 235 ist durch eine Stirnseite einer Glasfaser 239 gebildet, in welche wenigstens ein Teil der Photonen eingekoppelt und zu einem Lichtdetektor 241 geleitet wird. Der Lichtdetektor 241 kann bspw. einen Photomultiplier, eine Avalanche-Photodiode, eine Photodiode oder andere Arten geeigneter Lichtdetektoren umfassen. Die Lichtoptik 223 ist so konfiguriert, dass sie die Oberfläche 208 der Szintillator-Platte 207 in einen Bereich 243 optisch abbildet, in welchem die Lichtempfangsfläche 235 angeordnet ist. Aufgrund dieser optischen Abbildung werden optische Abbilder der Auftrefforte 213 in dem Bereich 243 erzeugt. Für einen jeden der Auftrefforte 213 ist in dem Bereich 243 eine separate Lichtempfangsfläche 235 des Lichtdetektionssystems 237 vorgesehen. Eine jede der weiteren Lichtempfangsflächen 235 (Signaleintrittsoberflächen 235) ist durch eine Stirnseite eines Lichtleiters 239 gebildet, welche das in die Stirnseite eingekoppelte Licht zu einem Lichtdetektor 241 leitet. Aufgrund der optischen Abbildung ist einem jedem der Auftrefforte 213 eine Lichtempfangsfläche 235 zugeordnet, wobei das in eine jeweilige Lichtempfangsfläche 235 eintretende Licht durch einen separaten Lichtdetektor 241 detektiert wird. Die Lichtdetektoren 241 geben über Signalleitungen 245 elektrische Signale aus. Diese elektrischen Signale repräsentieren Intensitäten der Teilchenstrahlen 9. Somit definieren die Orte auf der Oberfläche der Szintillator-Platte 207 welche auf die Lichtempfangsflächen von Lichtdetektoren 241 abgebildet werden, verschiedene Detektionspunkte oder Detektionsbereiche. Aufgrund der zuvor beschriebenen Elektronenoptik werden Wechselwirkungsprodukte, beispielsweise Elektronen, die aus zwei verschiedenen Einzelfeldbereichen eines Objektes austreten, auch auf verschiedene Detektionsbereiche der Szintillator-Platte 207 projiziert. In dem hier erläuterten Ausführungsbeispiel sind die Lichtdetektoren 241 entfernt von den Lichtempfangsflächen 235 angeordnet, auf die die Lichtoptik 223 die Szintillator-Platte 207 abbildet, und das empfangene Licht wird den Lichtdetektoren 241 durch Glasfasern 239 zugeleitet. Es ist jedoch auch möglich, dass die Lichtdetektoren 241 direkt dort angeordnet sind, wo die Lichtoptik das Bild der Szintillator-Platte erzeugt und die lichtempfindlichen Flächen der Lichtdetektoren somit die Lichtempfangsflächen bilden.

Fig. 2a erläutert dabei nur schematisch einige Details des Detektors 209. Es bleibt an dieser Stelle darauf hinzuweisen, dass durch die Rast- /Scanbewegung der Primär-Teilchenstrahlen über ein Objekt oder eine Probe viele Punkte der Probe bestrahlt bzw. abgetastet werden. Jeder Primär-Teilchenstrahl 3 überstreicht dabei ganz oder teilweise einen Einzelfeldbereich des Objektes. Dabei ist jedem Primär-Teilchenstrahl 3 ein eigener Einzelfeldbereich des Objektes zugewiesen. Aus diesen Einzelfeldbereichen des Objektes 7 treten nun wiederum Wechselwirkungsprodukte, z.B. Sekundärelektronen, aus dem Objekt 7 aus. Dann werden die Wechselwirkungsprodukte derart auf die Detektionsbereiche des Teilchendetektors bzw. auf die Szintillator-Platte 207 projiziert, das die von zwei verschiedenen Einzelfeldbereichen austretenden Wechselwirkungsprodukte auf verschiedene Detektionsbereiche der Szintillator-Platte 207 projiziert werden. Von jedem Detektionsbereich der Szintillator-Platte 207 werden bei einem Auftreffen der Wechselwirkungsprodukte, z.B. Sekundärelektronen, auf diesen Detektionsbereich Lichtsignale ausgesendet, wobei die von jedem Detektionsbereich ausgesendeten Lichtsignale einem dem jeweiligen Detektionsbereich zugeordneten Lichtdetektor 241 zugeführt werden. Mit anderen Worten ist es so, dass jeder Primär-Teilchenstrahl 3 seinen eigenen Detektionsbereich auf dem Szintillator 207 und auch seinen eigenen Lichtdetektor 241 umfasst, die im Normal-Inspektionsmodus zusammen einen Detektionskanal bilden.

Im Kontrast-Betriebsmodus treffen die zweiten Einzel-Teilchenstrahlen 9 defokussiert auf die Szintillatorplatte 207 auf. Die von einem Teilchenstrahl 9 getroffene Detektionsfläche vergrößert sich durch die Defokussierung, der dem Teilchenstrahl 9 zugeordnete Detektionsbereich 215 wächst. Die optische Abbildung der austretenden Photonen auf die Lichtempfangsflächen 235 bleibt aber im Prinzip unverändert, so dass je zweitem Einzelstrahl 9 nun Photonen in mehrere Lichtempfangsflächen 235 bzw. Glasfasern mit angeschlossenen Lichtdetektoren 241 gelangen. Einem Detektionsbereich 215, der bezogen auf einen Einzel-Teilchenstrahl definiert wird, sind dann also mehrere Detektionskanäle 235 zugeordnet.

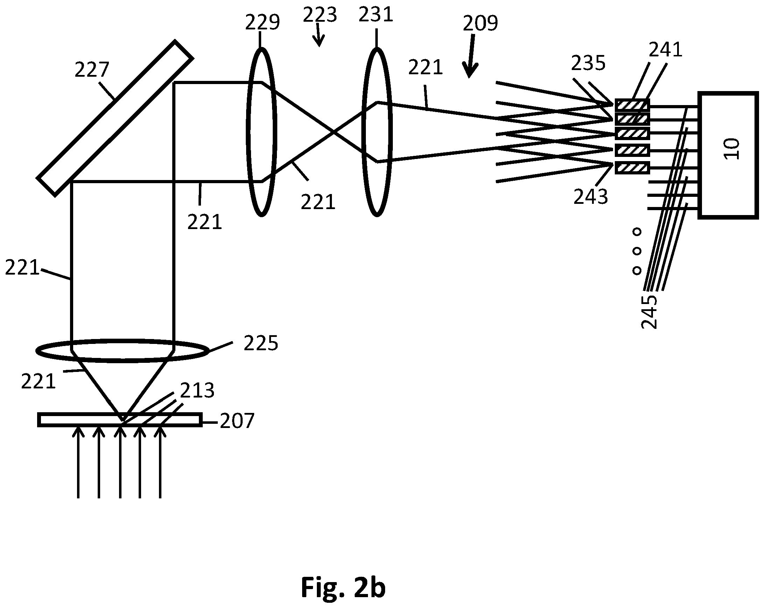

Fig. 2b zeigt eine alternative Ausführungsvariante eines Detektionssystems 209. Bei dieser Variante sind keine Glasfasern 239 vorgesehen, stattdessen treffen von der Szintillatorplatte 207 ausgehende Photonen nach der optischen Abbildung direkt auf ein Array mit lichtsensitiven Detektoren 241, beispielsweise ein Array umfassend Fotomultiplier, Fotodioden oder Avalanche-Fotodioden.

Auch andere als die in Fig. 2a und Fig. 2b dargestellte Detektions-Architektur sind für die Ausführung des erfindungsgemäßen Verfahrens zum Betreiben eines Vielstrahl-Teilchenmikroskops 1 in einem Normal-Betriebsmodus und in dem erfindungsgemäßen Kontrast-Betriebsmodus geeignet. Verwiesen wird beispielsweise auf die Methode der DED ("direct electron detection"), die ohne Lichtdetektoren auskommt und bei der Sekundärelektronen direkt in ein Stromsignal umgewandelt werden.

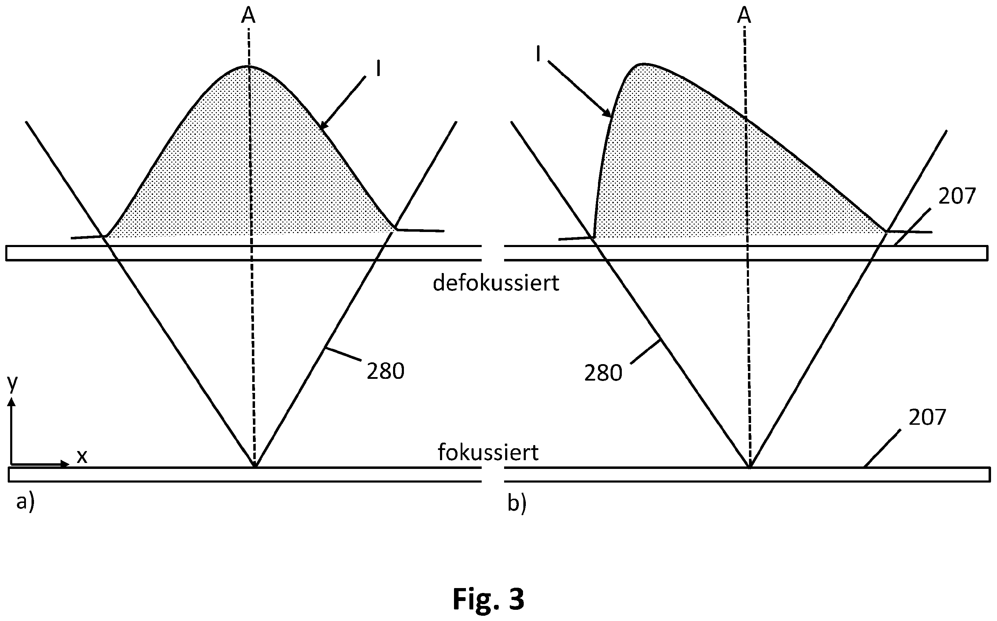

Fig. 3 vergleicht schematisch die Auswirkung einer Winkelverteilung von zweiten Einzel-Teilchenstrahlen 9 bei fokussierter und defokussierter Detektion. Dargestellt sind in Fig. 3 zwei verschiedene Fallsituationen: In Fall a wird angenommen, dass zweite Einzel-Teilchenstrahlen 9 detektiert werden, die von einer flachen Probe 7 ausgegangen sind. Die zweiten Einzel-Teilchenstrahlen 9 starten isotrop von der Probe. Im Fall b wird davon ausgegangen, dass zweite Einzel-Teilchenstrahlen 9 bzw. Sekundärstrahlen von einer strukturierten Probe 7 ausgegangen sind. Die zweiten Einzel-Teilchenstrahlen starten von der Probe anisotrop, d.h. mit einer anisotropen Richtungs- und oder Winkelverteilung. Die Darstellung in Fig. 3 zeigt nun die beiden unterschiedlichen Fälle bei der Detektion:
In Fall a ist bei der Detektion die Winkelverteilung der Sekundärelektronen symmetrisch um die Achse A, die orthogonal zur Detektionsebene angeordnet ist. Aufgetragen ist in Fig. 3a auf der Y-Achse bezeichnet mit I die Sekundärelektronenausbeute. Weiterhin ist schematisch der Strahlkegel 280 eingezeichnet. Unten in der Abbildung von Fig. 3a ist der fokussierte Einfall von Sekundärstrahlen auf der Detektionsfläche 207 dargestellt, oben in der Figur ist der defokussierte Einfall dargestellt. Bei fokussiertem Einfall auf die Detektionsfläche 207 wird keine zusätzliche Information über die Winkelverteilung der zweiten Einzel-Teilchenstrahlen gewonnen, sie geht bei fokussierter Detektion quasi verloren. Im defokussierten Fall hingegen ist die Winkelverteilung der zweiten Einzel-Teilchenstrahlen vorhanden, bei der Detektion wird sie in der Ortsverteilung auf dem Detektor bzw. der Detektionsfläche 207 wiedergegeben.

Im Falle einer flachen Probe ist die Sekundärelektronenausbeute isotrop um die Achse A, im Falle einer strukturierten Probe ist die Sekundärelektronenausbeute I anisotrop, das Maximum befindet sich im gezeigten Beispiel links von der Symmetrieachse A. Grundsätzlich ermöglicht also eine defokussierte Detektion von Sekundärstrahlen das Erhalten von Winkelinformation und/oder Richtungsinformation der zweiten Einzel-Teilchenstrahlen 9 beim Starten von einem Objekt 7. Sie wird zugänglich durch eine ortsaufgelöste Detektion der Sekundärstrahlen 9 bzw. zugeordneter Photonen bei Verwendung von Lichtdetektoren 241.

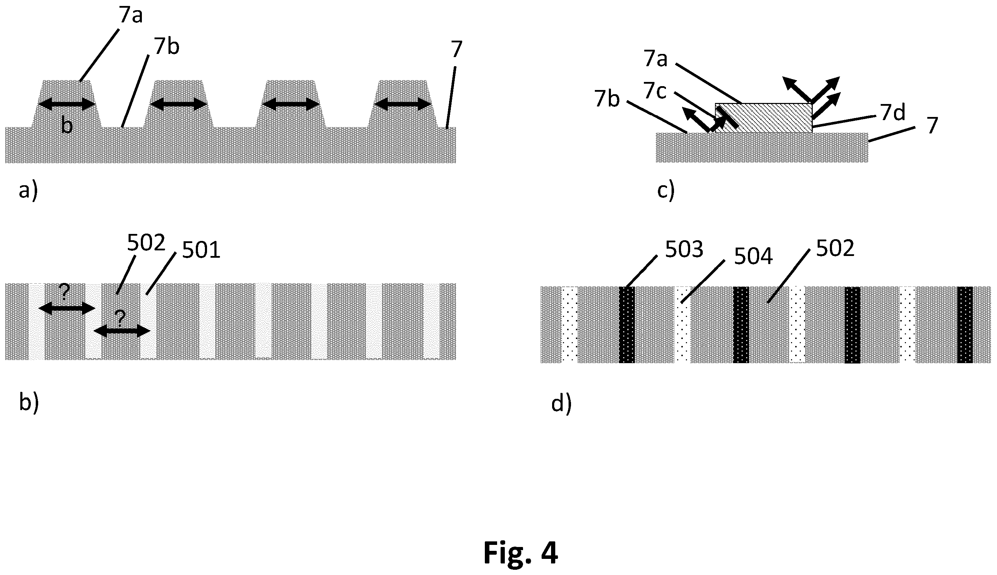

Fig. 4 illustriert ein Anwendungsbeispiel für die Erfindung. Fig. 4a zeigt dabei in einer Seitenansicht eine strukturierte Probe 7, in der abwechselnd Erhebungen 7a und Vertiefungen 7b angeordnet sind. Die Breite einer Erhebung 7a ist mit b bezeichnet. Bei einer Inspektion von Halbleiterproben muss diese Breite b häufig ermittelt werden. Die zugrunde liegende Frage betrifft den sogenannten Kantenkontrast (Topografiekontrast). Ein dazugehöriges elektronenoptisch gewonnenes Bild zeigt Fig. 4b: Bei dieser Aufnahme erfolgt die Abbildung der Sekundärelektronenstrahlen auf den Detektor 209 fokussiert. Im Ergebnis zeigt das Bild gemäß Fig. 4b abwechselnd breite Streifen 502 und schmale Streifen 501. Es ist jedoch bei der fokussierten Abbildung nicht zu unterscheiden, ob ein breiter Streifen 502 einer Erhebung 7a oder einer Vertiefung 7b zuzuordnen ist.

Die Situation bei Verwendung eines erfindungsgemäßen Kontrast-Betriebsverfahrens des Vielstrahl-Teilchenmikroskopes 1 ist demgegenüber eine andere: Fig. 4c zeigt schematisch eine strukturierte Probe 7 und das Austreten von Sekundärstrahlen bzw. zweiten Einzel-Teilchenstrahlen 9 aus der Probe 7. Die Sekundärteilchen sind durch die Pfeile in Fig. 4c illustriert. Betrachtet wird zunächst die Situation an der linken Kante 7c der Probe 7: An der Kante 7c von der Probe 7 startende Sekundärelektronen 9 weisen eine Winkelverteilung auf. Nach links startende Sekundärelektronen 9 können tendenziell ungehindert von der Probe 7 starten, nach rechts startende bzw. ausgelöste Sekundärelektronen 9 werden tendenziell durch die Erhebung 7a der Probe 7 abgeschattet bzw. absorbiert. An der linken Kante 7c weisen die Sekundärelektronen 9 deshalb tendenziell mehr Teilchen auf, die nach links von der Probe starten. Die umgekehrte Situation ergibt sich an der Kante 7d der Probe 7: Hier können auch aus der seitlichen Flanke 7d Sekundärelektronen 9 austreten, das Winkelspektrum der von der Probe 7 startenden Sekundärelektronen umfasst deshalb tendenziell mehr nach rechts abgelenkte Sekundärteilchen 9 als nach links abgelenkte Sekundärteilchen 9.

Fig. 4d zeigt nun eine elektronenoptische Aufnahme, bei der die Sekundärstrahlen defokussiert und ortsaufgelöst detektiert worden sind: Durch die Verwendung von Winkelinformation und/oder Richtungsinformation der zweiten Einzel-Teilchenstrahlen 9 beim Starten von dem Objekt 7 lassen sich in der Aufnahme die schmalen Bereiche 503 und 504 voneinander unterscheiden: Die dunkel dargestellten Streifen 503 entsprechen jeweils einer abfallenden Kante in Fig. 4a, die hellen Streifen 504 entsprechen jeweils einer ansteigenden Kante in Fig. 4a. Durch die Verwendung des erfindungsgemäßen Verfahrens lässt sich also verbesserte bzw. gemäß dem Stand der Technik bisher nicht zugängliche Kontrastinformation beim Abscannen einer Probe 7 erhalten.

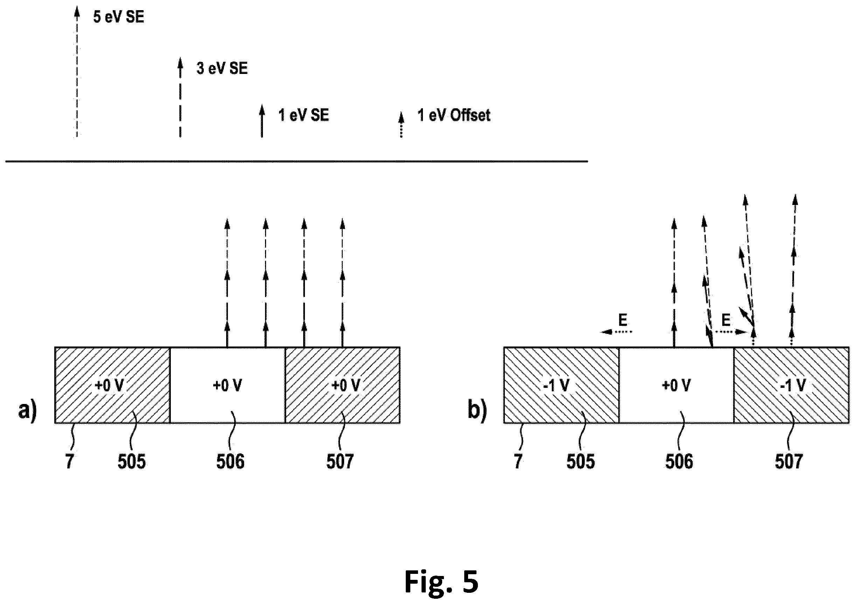

Fig. 5 illustriert ein weiteres Anwendungsbeispiel für die Erfindung, und zwar bei der Untersuchung von aufgeladenen Proben. Die Untersuchung von Aufladungen auf Proben 7 erfolgt im Zuge der Ermittlung eines sogenannten Spannungskontrasts. Dieser ist insbesondere bei den sogenannten elektrischen Antwortmessungen (engl.: "electric response measurements") von Bedeutung. Mit herkömmlichen Inspektionsmethoden (fokussierte Detektion) lassen sich einige Arten von Defekten (Widerstandsdefekte, Leckagedefekte) nämlich nicht detektieren. Das ist bei einer defokussierten Detektion von zweiten Einzel-Teilchenstrahlen 9 sowie bei Verwendung von mehreren ortsaufgelösten Detektionskanälen je Detektionsbereich anders. Im Falle von Aufladungen auf einer Probe verändert sich nämlich das Winkelspektrum der von der Probe startenden Sekundärelektronen bzw. zweiten Einzel-Teilchenstrahlen 9. Dies ist in Fig. 5 dargestellt: Fig. 5a zeigt eine Probe 7 mit verschiedenen Bereichen 505, 506 und 507, die jeweils nicht aufgeladen sind. Von diesen Bereichen bzw. deren Oberfläche gehen verschiedene Sekundärelektronen aus, sie starten in dieser Veranschaulichung jeweils senkrecht und weisen unterschiedliche Energien auf. Im gezeigten Beispiel sind dies Elektronen mit 5 eV, 3 eV und 1 eV, die unterschiedlichen Energien sind durch die unterschiedliche Strichelung der Pfeile in Fig. 5 codiert. Mit anderen Winkeln startende Sekundärelektronen (nicht dargestellt) werden ebenso beeinflusst, so dass sich entsprechend der Aufladungsdifferenz eine asymmetrische Winkelverteilung der Sekundärelektronen ergibt.

In Fig. 5b sind die Probenbereiche 505 und 507 negativ geladen, im dargestellten Beispiel sind dies -1V. Dadurch wird zwischen den Bereichen 505 und 506 sowie 506 und 507 ein elektrisches Feld E erzeugt. Die von der Probe startenden Sekundärelektronen 9 werden durch dieses elektrische Feld E richtungsmäßig abgelenkt, hinzu kommt ein Offset an den negativ aufgeladenen Probenbereichen 505 und 507 (der Offset ist durch den kurzen gestrichelten Pfeil angedeutet). Durch die Aufladung der Probe 7 verändert sich also das Winkelspektrum (Orts- und/ oder Richtungsinformation) der von der Probe 7 ausgehenden Sekundärteilchen 9. Bei defokussierter Detektion wird diese Information aus dem Winkelspektrum in Ortsinformation transferiert und sie wird bei entsprechender Mehrkanalmessung messbar bzw. nutzbar gemacht.

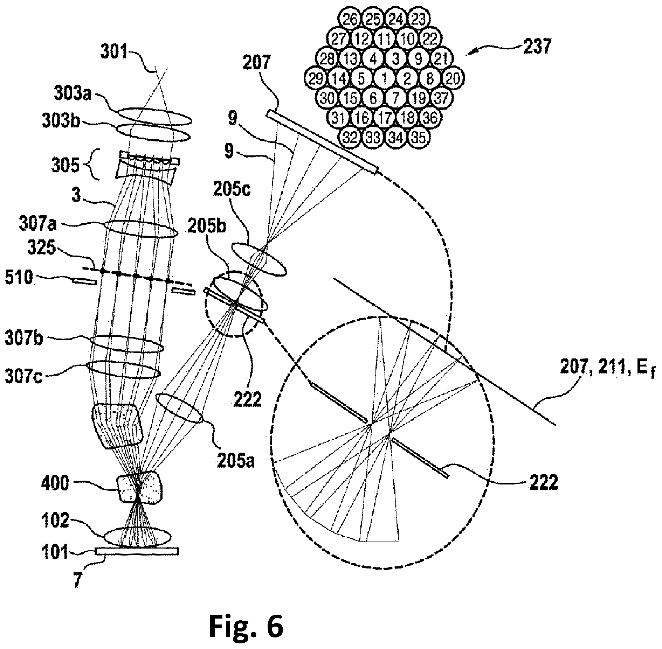

Fig. 6 zeigt schematisch eine Detektion fokussierter Sekundärstrahlen 9 in einem Normal-Inspektionsmodus, der im Prinzip aus dem Stand der Technik bekannt ist. Von einer Teilchenquelle 301 wird ein divergenter Teilchenstrahl ausgesendet, der im gezeigten Beispiel ein Kondensorlinsensystem 303a, 303b durchsetzt und im gezeigten Beispiel kollimiert auf einen Vielstrahl-Teilchengenerator 305 trifft und diesen durchsetzt. Dieser kann beispielsweise eine Multiaperturplatte mit einer darauffolgenden Gegenelektrode aufweisen, es sind aber auch andere Ausführungsvarianten möglich. Es ist theoretisch natürlich auch möglich, gleich eine Vielstrahl-Teilchenquelle 301 zu verwenden, sodass die ersten Einzel-Teilchenstrahlen 3 nicht extra durch einen Vielstrahl-Teilchengenerator 305 gebildet werden müssen.

Im weiteren teilchenoptischen Strahlengang durchsetzen die ersten Einzel-Teilchenstrahlen 3 im dargestellten Beispiel ein Feldlinsensystem mit den Feldlinsen 307a, 307b und 307c. Anschließend passieren sie eine Strahlweiche 400 sowie eine insbesondere magnetische Objektivlinse 102, dann treffen die ersten Einzel-Teilchenstrahlen 3 fokussiert auf das Objekt 7 in der Objektebene 101 auf. Durch das Auftreffen der ersten Einzel-Teilchenstrahlen 3 werden aus der Probe bzw. dem Objekt 7 die zweiten Einzel-Teilchenstrahlen 9 ausgelöst. Diese durchsetzen ebenfalls die Objektivlinse 102 und die Strahlweiche 400 sowie im dargestellten Beispiel anschließend ein Projektionslinsensystem 205a, 205b, 205c. Im Projektionslinsensystem 205 ist in einer Strahlüberkreuzung (engl. "cross-over") der zweiten Einzel-Teilchenstrahlen 9 eine Kontrastblende 222 angeordnet. Bei dieser Kontrastblende 222 kann es sich beispielsweise um eine Kreisblende oder um eine Ringblende handeln. Es kann sich um eine Hellfeldblende oder um eine Dunkelfeldblende handeln. Die Kontrastblende hat die Aufgabe, zweite Einzel-Teilchenstrahlen 9 nach ihren Startwinkeln von der Objektebene 101 zu filtern. Zweite Einzel-Teilchenstrahlen 9 ab einem/bis hin zu einem bestimmten Startwinkelbereich werden aus dem Büschel der zweiten Einzel-Teilchenstrahlen 9 in der Strahlüberkreuzung ausgeschnitten. Dies ist in dem vergrößert dargestellten Kreis in Fig. 6 schematisch illustriert. Der Strahlengang in Fig. 6 ist - wie bereits ausgeführt - nur schematisch und somit zwangsweise stark vereinfacht dargestellt. In dem in Fig. 6 dargestellten Normal-Inspektionsmodus treffen die zweiten Einzel-Teilchenstrahlen 9 fokussiert auf die Detektionsebene 207 bzw. den Szintillator 207 auf. Dem Szintillator 207 ist der Lichtdetektor 237 nachgeschaltet, der in Fig. 6 schematisch durch die hexagonale Anordnung von Detektionskanälen 1 bis 37 dargestellt ist, deren Querschnitt bzw. Signaleintrittsfläche 235 hier als Kreis ausgestaltet ist. Bei der in Fig. 6 dargestellten Abbildung ist es so, dass die Objektebene 101 fokussiert auf den Szintillator 207 bzw. die Ebene E_{f} abgebildet wird. Außerdem ist es so, dass bevorzugt alle Einzel-Teilchenstrahlen 3, 9 für die Abbildung verwendet werden, um einen möglichst großen Durchsatz bei der Bildgebung zu erzielen.

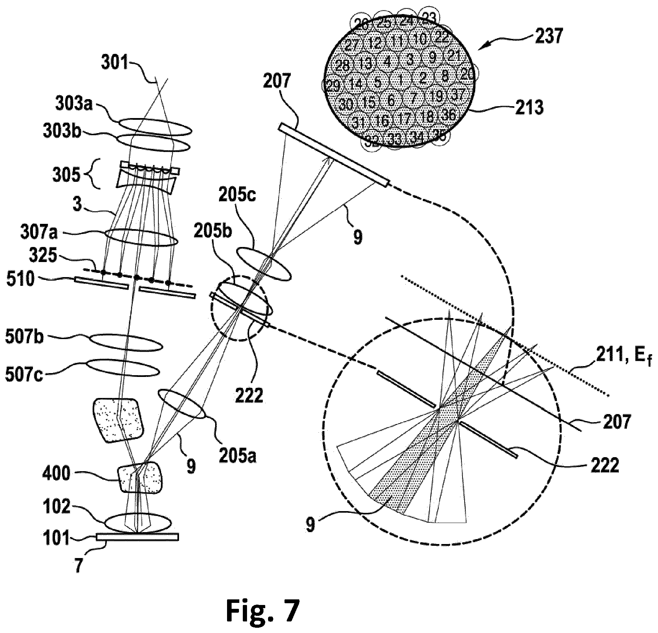

Fig. 7 zeigt nun schematisch eine Detektion defokussierter Sekundärstrahlen 9 in einem erfindungsgemäßen Kontrast-Betriebsmodus des Vielstrahl-Teilchenmikroskops 1. Die Fig. 6 und 7 sind in weiten Teilen identisch miteinander, im Folgenden wird deshalb nur auf die Unterschiede von Fig. 7 verglichen mit Fig. 6 eingegangen. Der Sekundärpfad in Fig. 7 ist beispielsweise über das Projektionslinsensystem 205a, 205b, 205c so eingestellt, dass die zweiten Einzel-Teilchenstrahlen 9 nicht fokussiert, sondern defokussiert auf die Detektionsfläche bzw. im gezeigten Beispiel auf den Szintillator 207 auftreffen. Dabei zeigt Fig. 7 exemplarisch eine Defokussierung bei Verwendung nur eines Einzel-Teilchenstrahls 9, in der Praxis werden bevorzugt mehrere zweite Einzel-Teilchenstrahlen verwendet; hierzu folgen unten noch weitere Ausführungen. Der zweite Einzel-Teilchenstrahl 9 durchsetzt die Kontrastblende 222 im (theoretischen) Überkreuzungspunkt der zweiten Einzel-Teilchenstrahlen 9 miteinander. Dann trifft der defokussierte Einzel-Teilchenstrahl 9 auf den Szintillator 207 auf, durch entsprechende Einstellung der Projektionslinse(n) 205b, 205c ist die Lage der Detektionsebene/ des Szintillators 207 nicht mehr identisch mit der Lage der Fokusebene E_{f}. Durch die Defokussierung vergrößert sich auch die Auftrefffläche des zweiten Einzel-Teilchenstrahls 9 auf dem Detektor, mit anderen Worten die Größe des Detektionsbereiches 215 verändert sich. Der physikalische Detektor 207, 209 ist aber nach wie vor derselbe, er ist bevorzugt räumlich fix. Deshalb treffen aus der Szintillatorplatte 207 ausgelöste Photonen jetzt auf mehrere Detektionskanäle des Lichtdetektors 237. Fig. 7 zeigt exemplarisch den Beleuchtungsfleck 213 beim Auftreffen der Photonen auf die Signaleintrittsoberflächen/Lichtempfangsflächen 235 des Glasfaserbündels des Lichtdetektors 237. Es ist aber natürlich auch möglich, andere Detektionssysteme zu verwenden. Fig. 7 zeigt insofern nur das Prinzip.

Außerdem ist es gemäß Fig. 7 bevorzugt, dass eine Anzahl von zweiten Einzel-Teilchenstrahlen 9, die in dem Kontrast-Betriebsmodus auf die Detektionseinheit 207, 209 auftreffen, ausgewählt wird und dass alle übrigen Einzel-Teilchenstrahlen ausgeblendet werden. Im gezeigten Beispiel geschieht dies bereits im Primärpfad durch einen Strahl-Selektor 510. Dieser kann wahlweise einen einzelnen, zwei, drei oder eine andere beliebige Anzahl der Einzel-Teilchenstrahlen 3 bereits im Primärpfad ausblenden. Zusätzlich oder alternativ ist es auch möglich, im Sekundärpfad einen oder mehrere zweite Einzel-Teilchenstrahlen 9 aus dem Sekundärpfad auszublenden.

Je nach Anwendung ist es möglich, die Defokussierung der zweiten Einzel-Teilchenstrahlen 9 beim Auftreffen auf die Detektionseinheit 209 einzustellen, insbesondere basierend auf der ausgewählten Kontrastblende. Es ist auch möglich, mehrere Kontrastblenden nacheinander vorzusehen. Außerdem kann die Kontrastblende in den Strahlengang eingefahren werden oder es kann eine sektorisierte Kontrastblende vorgesehen sein, die unterschiedliche Blenden aufweist, die wahlweise von den zweiten Einzel-Teilchenstrahlen durchsetzt werden können. Dazu kann die sektorisierte Kontrastblende z.B. drehbar gelagert sein oder es ist möglich, den Pfad der zweiten Einzel-Teilchenstrahlen entsprechend so zu verändern, dass ein bestimmter Sektor durchsetzt wird.

Außerdem ist es möglich, eine Anzahl von Detektionskanälen je Detektionsbereich bzw. je Sekundär-Teilchenstrahl 9 auszuwählen bzw. festzusetzen. Zusätzlich oder alternativ kann das Einstellen eines Pitches der zweiten Einzel-Teilchenstrahlen 9 beim Auftreffen auf die Detektionseinheit 207, 209 erfolgen, beispielsweise basierend auf der ausgewählten Kontrastblende 222 und/oder der eingestellten Defokussierung und/oder der ausgewählten Anzahl der Detektionskanäle 235 je Detektionsbereich 215. Außerdem ist es möglich, das Vielstrahl-Teilchenmikroskop abwechselnd in einem Normal-Inspektionsmodus (fokussierte Detektion) und in einem Kontrast-Betriebsmodus (defokussierte Detektion) zu betreiben. Es ist möglich, dass in einer Steuerung 10 des Vielstrahl-Teilchenmikroskops 1 verschiedene Kontrast-Betriebsmodi mit zugehörigen Betriebsparametern hinterlegt sind und dass einer der hinterlegten Kontrast-Betriebsmodi ausgewählt wird und das Vielstrahl-Teilchenmikroskop 1 in diesem ausgewählten Kontrast-Betriebsmodus betrieben wird.

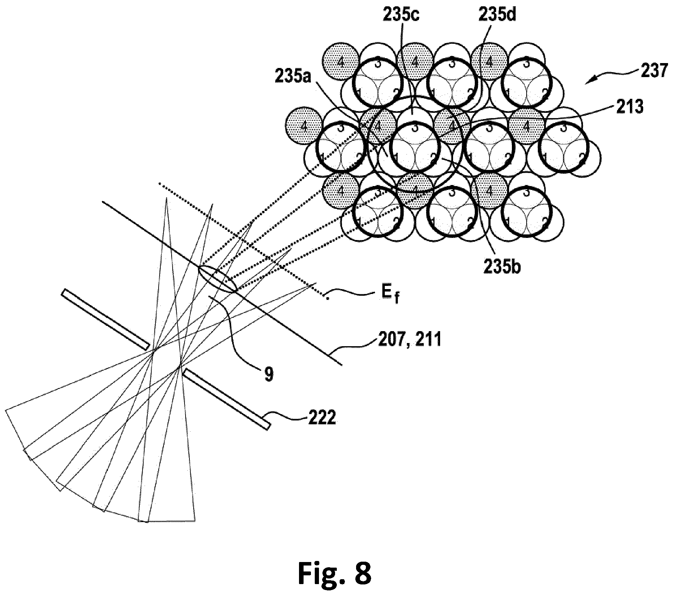

Fig. 8 zeigt schematisch eine Detektion defokussierter Sekundärstrahlen 9 mit drei Detektionskanälen 235 je Detektionsbereich 215. Dargestellt ist die Projektion vom Teilchendetektor, hier eine Szintillatorplatte 207, auf einen Lichtdetektor 237 mit den Signaleintrittsflächen 235 eines Glasfaserbündels 239. Die Projektion ist durch die gepunkteten Striche in Fig. 8 angedeutet. Die Zuordnung von Detektionskanälen 235 zu den Glasfasern 237 ist durch die Nummerierung 1, 2, 3, 4 angedeutet. Mit den Nummern 1, 2, 3 werden aktive Detektionskanäle 235 bezeichnet, mit der Nummer 4 werden inaktive Detektionskanäle 235 bezeichnet. Exemplarisch mit 235a, 235b und 235c sind die drei Detektionskanäle bezeichnet, die vom Strahlfleck 213 überdeckt werden. Insgesamt zeigt Fig. 8 die Detektion von sieben zweiten Einzel-Teilchenstrahlen 9. Zu erkennen ist außerdem, dass die Strahlflecken 213, die jedem der zweiten Einzel-Teilchenstrahlen 9 zuzuordnen sind, nicht miteinander überlappen. Ein Übersprechen zwischen verschiedenen Detektionsbereichen 215 wird dadurch vermieden. Der Strahlpitch der zweiten Einzel-Teilchenstrahlen 9 beim Auftreffen auf den Detektor 207 ist entsprechend eingestellt. Es ist möglich, die im Prinzip nicht-aktiven Detektionskanäle 4 in den Zwischenräumen zwischen den aktiven Detektionskanälen 1, 2, 3 dazu zu verwenden, um das Auftreten eines möglichen Übersprechens (engl. "cross-talk") zu detektieren. Außerdem ist es möglich, etwaige Signale in den Detektionskanälen 4 dazu zu verwenden zu überprüfen, ob die Ausrichtung der Strahlen auf den Detektor korrekt ist. Im gezeigten Beispiel zielt das Zentrum der Strahlen genau auf einen Zwischenbereich zwischen den Detektionskanälen 1, 2 und 3. Wird nun zusätzlich in den Kanälen 4 Signal detektiert, so ist die Ausrichtung (engl. "alignment") der Strahlen zum Detektor 209 nicht optimal und muss korrigiert werden.

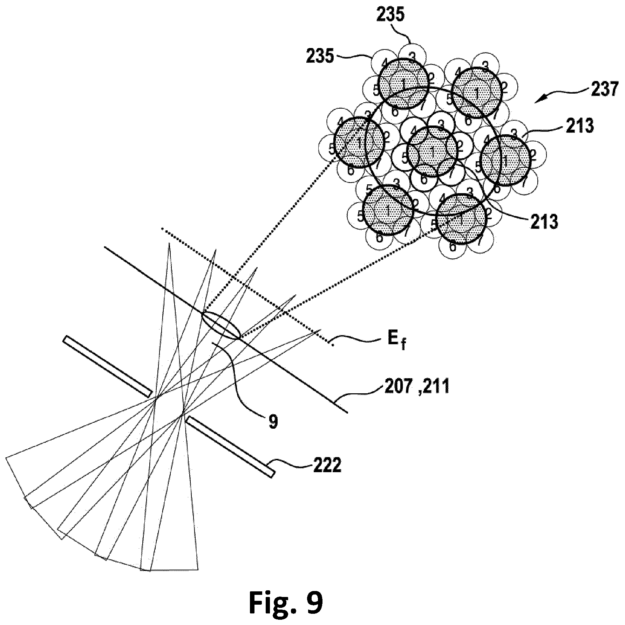

Fig. 9 zeigt schematisch eine Detektion defokussierter Sekundärstrahlen 9 mit sieben Detektionskanälen 235 je Detektionsbereich 215. Die Strahlflecken 213 jedes Strahls treffen dabei auf sieben Signaleintrittsoberflächen 235 von Glasfasern 237 auf. Verwendet werden im gezeigten Beispiel wiederum sieben zweite Einzel-Teilchenstrahlen 9 für die Detektion. Insgesamt ergibt sich im dargestellten Beispiel ein hexagonales Muster von Detektionsbereichen 215. Im Übrigen wird auf die Ausführungen hinsichtlich Fig. 8 verwiesen.

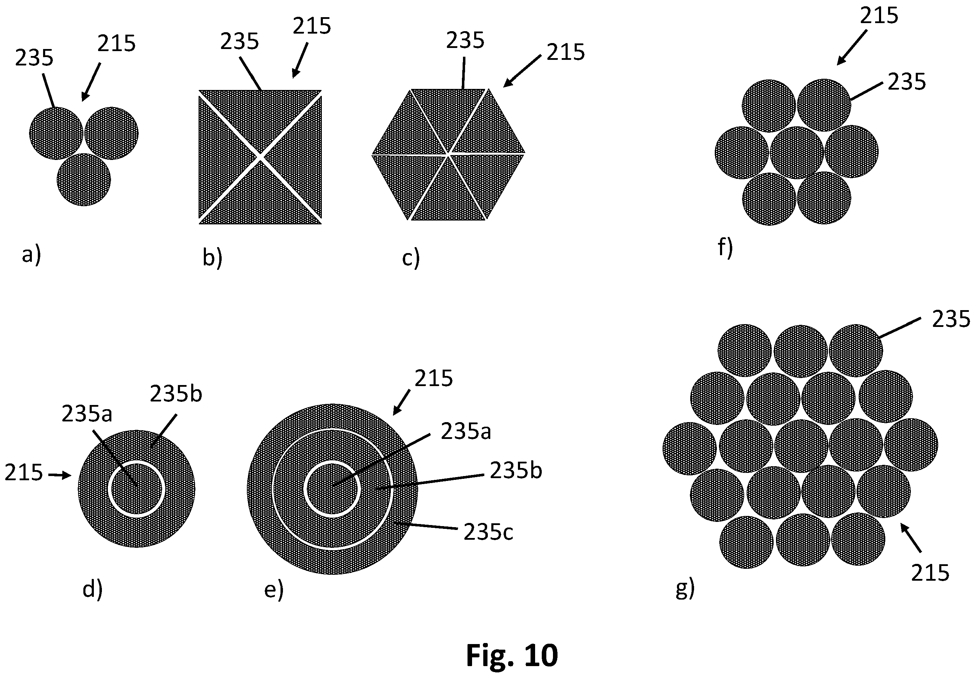

Fig. 10 illustriert schematisch verschiedene Geometrien von Detektionsbereichen 215 und Detektionskanälen 235. Fig. 10a, b und c zeigen dabei Detektionsbereiche 215, deren Detektionskanäle 235 richtungssensitiv angeordnet sind. Gemäß dem Beispiel in Fig. 10a sind die Detektionskanäle 235 bzw. die Signaleintrittsflächen 235 kreisförmig, der Detektionsbereich 215 bildet ein Dreieck. In Fig. 10b sind die Detektionskanäle 235 als gleichschenklige Dreiecke ausgebildet, der Detektionsbereich 215 umfasst vier Sektoren und insgesamt ergibt sich als Detektionsbereich 215 ein Quadrat. Fig. 10c zeigt einen hexagonalen Detektionsbereich 215, der sechs Sektoren umfasst, wobei jeder Kanal 235 durch gleichseitige Dreiecke 235 gebildet werden.

Die Fig. 10d und 10e zeigen jeweils radialsensitive Anordnungen von Detektionskanälen 235. In Fig. 10d ist der innerste Detektionskanal 235a als Kreis ausgebildet. Konzentrisch um diesen Kreis 235a herum befindet sich der Kreisring des Detektionskanals 235b. In Fig. 10e befindet sich ein weiterer kreisringförmiger Detektionskanal 235c konzentrisch um die beiden anderen Detektionskanäle 235a, 235b. Mittels der radialsensitiven Anordnung von Detektionskanälen 235 bzw. mittels entsprechend aufgebauter Detektionsbereiche 215 lässt sich Winkelinformation von zweiten Einzel-Teilchenstrahlen 9 beim Starten von einem Objekt 7 codieren.

Fig. 10f und 10g zeigen eine sowohl richtungssensitive als auch radialsensitive Anordnung von Detektionskanälen 235. In Fig. 10f sind sieben kreisförmige Detektionskanäle 235 dichtest gepackt, sodass sich insgesamt eine hexagonale Anordnung der Detektionskanäle 235 ergibt. Sie können zusammen einen Detektionsbereich 215 bilden. Fig. 10g zeigt im Prinzip eine weitere Schale: Hier ist außen um die sieben Detektionskanäle 235 aus Fig. 10f eine weitere Schale aus Detektionskanälen 235 angeordnet. Es ist möglich, die Detektionskanäle 235 zu einer innersten Schale mit genau sieben Detektionskanälen und einer weiteren Schale mit weiteren zwölf Detektionskanälen zusammenzuschalten zu einem Detektionsbereich 215. Aber auch andere oder erweiterte Kombinationen sind möglich.

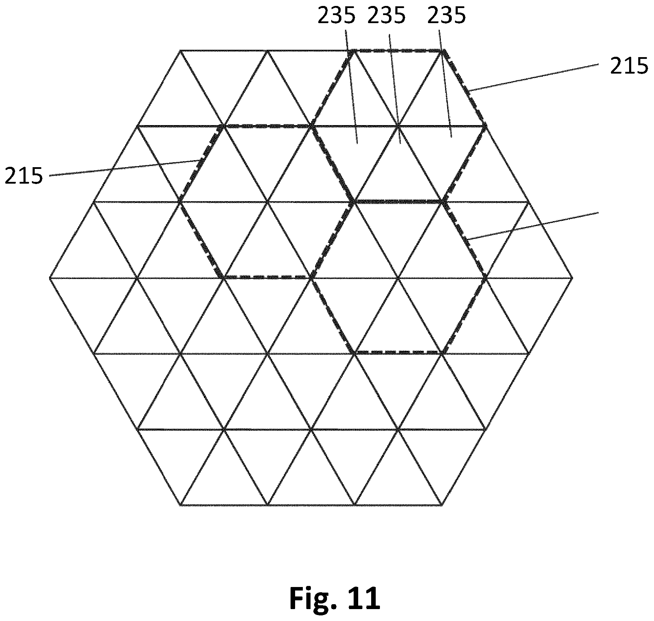

Fig. 11 illustriert schematisch eine weitere Geometrie von Detektionsbereichen 215 und Detektionskanälen 235. Die einzelnen Detektionskanäle 235 werden im dargestellten Beispiel durch gleichseitige Dreiecke gebildet, die jeweils zu hexagonalen Detektionsbereichen 215 zusammengefasst sind. Die hexagonalen Detektionsbereiche 215 können wiederum insgesamt so aneinandergesetzt werden, dass eine hexagonale Gesamtanordnung gebildet wird, Fig. 11 zeigt hier insofern nur einen Ausschnitt.

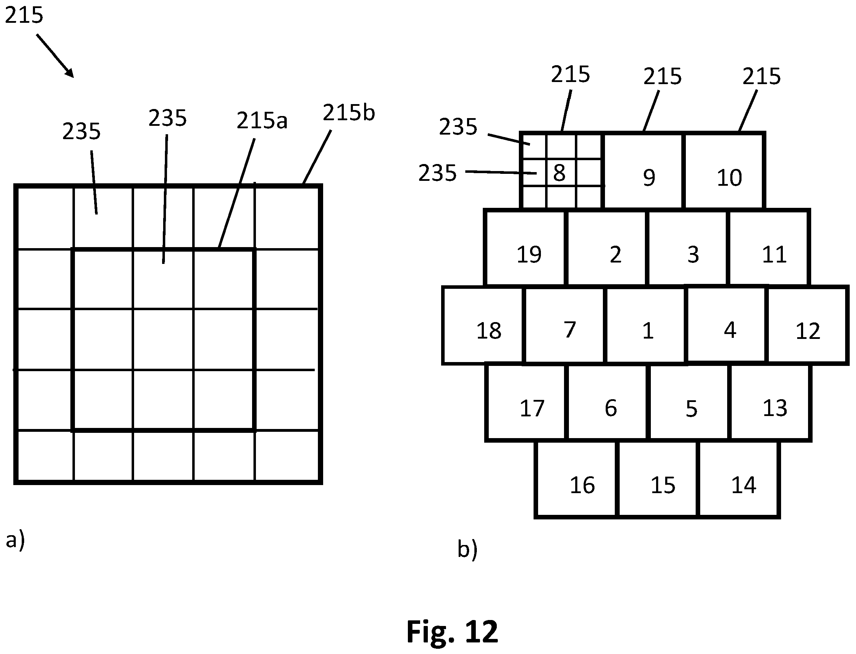

Fig. 12 illustriert schematisch weitere verschiedene Geometrien von Detektionsbereichen 215 und Detektionskanälen 235. Im Beispiel gemäß Fig. 12a sind die Detektionskanäle 235 rechteckig. Neun Rechtecke bilden dabei einen Detektionsbereich 215a. Dieser kann als innerste Schale bei einer schalenartigen Anordnung von Detektionsbereichen 215 aufgefasst werden. Um diese innerste Schale 215a herum sind genau sechzehn weitere Detektionskanäle 235 als Schale 215b angeordnet. Fig. 12b zeigt eine andere Anordnung von Detektionskanälen 235, die ebenfalls rechteckig sind. Diese werden jeweils zu rechteckigen Detektionsbereichen 215 zusammengefasst, die insgesamt hexagonal angeordnet sind. Fig. 12B zeigt exemplarisch neunzehn Detektionsbereiche 215, die jeweils radial und richtungssensitiv sind. Aber auch andere Anordnungen und Kombinationen sind möglich.

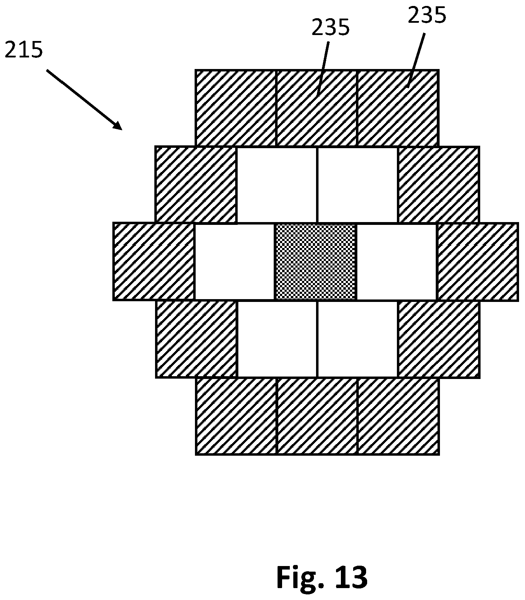

Fig. 13 illustriert schematisch eine weitere Geometrie von Detektionskanälen 235 eines Detektionsbereiches 215. Die einzelnen Detektionskanäle 235 sind im gezeigten Beispiel quadratisch oder rechteckig ausgebildet, der Detektionsbereich 215 ist insgesamt hexagonal. Durch die verschiedenen Schattierungen in Fig. 13 wird ein möglicher schalenartiger Aufbau des Detektionsbereiches 215 illustriert.

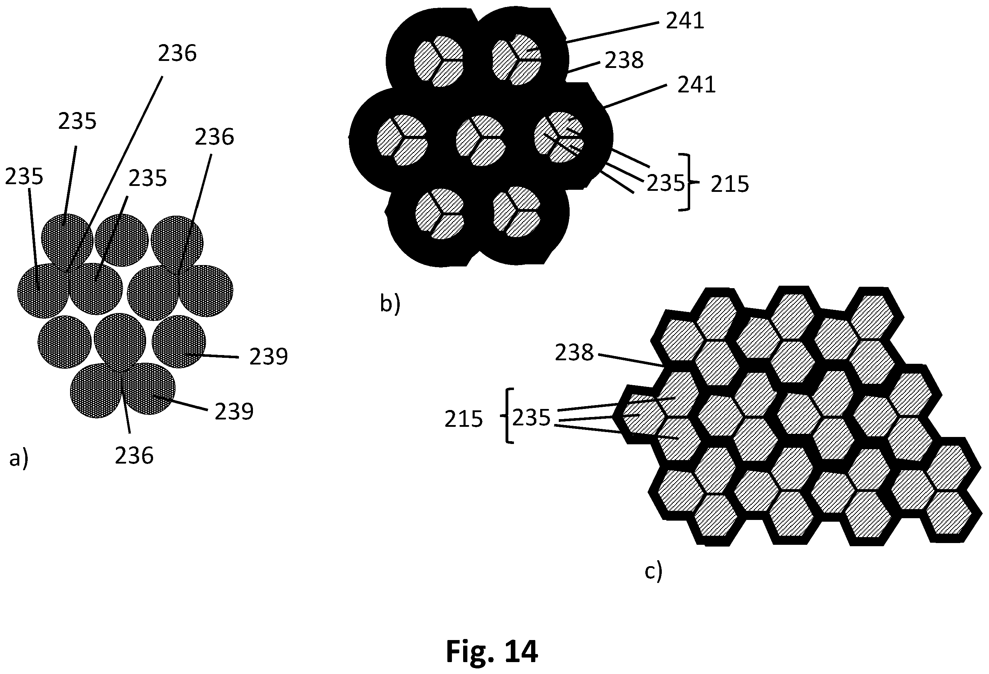

Fig. 14 illustriert schematisch weitere Ausführungsvarianten für Detektionsbereiche 215 und Detektionskanäle 235. Fig. 14a zeigt diverse Glasfasern 239 mit runder oder tropfenförmiger Signaleintrittsoberfläche, die jeweils Detektionskanäle 235 bilden. Im gezeigten Beispiel sind jeweils drei tropfenförmige Detektionskanäle 235 am Verbindungspunkt 236 miteinander verbunden, hier durch Laserschweißen. Im gezeigten Beispiel sind nur solche Detektionskanäle 235 bzw. Glasfasern 239 miteinander verbunden, die im Kontrast-Betriebsmodus demselben Detektionsbereich 215 zuzuordnen sind. Ein eventuelles Übersprechen zwischen den verbundenen Detektionskanälen hat deshalb kaum Auswirkungen auf das Gesamtsignal des Detektionsbereiches 215. Alternativ wäre es aber auch möglich, alle Glasfasern 239 oder Detektionskanäle 235 miteinander zu verbinden oder zumindest an einer Nahtstelle zu verschmelzen, sofern dadurch entstehender Crosstalk tolerabel ist.

Fig. 14b zeigt schematisch als Lichtdetektionssystem ein Array mit lichtempfindlichen Detektoreinheiten 241, das im gezeigten Beispiel keine Glasfasern 239 aufweist. Stattdessen kann es sich um ein Array umfassend Fotomultiplier, Fotodioden oder Avalanche-Fotodioden oder Ähnliches handeln. Die einzelnen Lichtdetektoreinheiten 241 sind sektoriert (hier: drei Sektoren bzw. Kanäle). Tote Bereiche 238 zwischen den Lichtdetektoreinheiten 241 bieten beispielsweise Platz für eine Verkabelung.

Fig. 14c zeigt schematisch eine Anordnung von hexagonalen Detektionskanälen 235. Diese können durch Tesselation im Prinzip lückenlos aneinandergefügt sein. Im gezeigten Beispiel sind jeweils drei Detektionskanäle zu einem Detektionsbereich 215 zusammengefasst. Tote Bereiche 238 zwischen den Detektionsbereichen 215 dienen der Reduzierung von Crosstalk.

Für sämtliche in den Fig. 10 bis 14 dargestellten Detektionsbereiche 215 und Detektionskanäle 235 gilt, dass diese einem Teilchendetektor und/oder einem Lichtdetektor zuzuordnen sein können, auch wenn viele der Beispiele besonders gut durch eine Kombination aus Teilchendetektor mit nachfolgendem Lichtdetektor realisiert werden können. Die beschriebenen Ausführungsvarianten sind insofern nicht einschränkend zu verstehen.

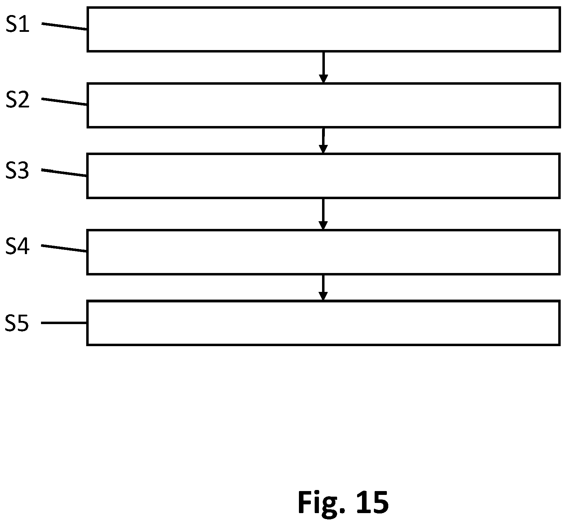

Fig. 15 zeigt beispielhaften einen Workflow, bei dem das erfindungsgemäße Verfahren eingesetzt wird. In einem ersten Verfahrensschritt S1 erfolgt eine Aufnahme der Probe in einem Kontrast-Betriebsmodus, wobei nur ein defokussierter zweiter Einzel-Teilchenstrahl oder nur einige wenige defokussierte zweite Einzel-Teilchenstrahlen mit möglichst vielen Detektionskanälen pro zweitem Einzel-Teilchenstrahl verwendet werden. Ein solcher Kontrast-Betriebsmodus kann auch als Kontrast-Review-Modus bezeichnet werden. Diese Aufnahme enthält sehr viel Winkelinformation und/ oder Richtungsinformation, ist aber verhältnismäßig zeitaufwendig.

In einem weiteren Verfahrensschritt S2 werden auf einer grafischen Benutzeroberfläche Kontrastbilder verschiedenen Typs dargestellt. Diese Kontrastbilder basieren alle auf der Aufnahme im Kontrast-Review-Modus. Die Signale der Detektionskanäle 23 werden jedoch verschieden ausgewertet, wodurch es möglich wird, mittels einer Aufnahme unterschiedliche Kontrastinformation zu generieren.

Ein Benutzer des Vielstrahl-Teilchenmikrokops kann nun in einem weiteren Schritt S3 z.B. durch eine Eingabe eine (oder mehrere) Darstellungen markieren, die für ihn besonders interessant ist. Es erfolgt also in Schritt S3 ein Auswählen einer Kontrastdarstellung.

In einem weiteren Verfahrensschritt S4 wird durch einen z.B. in der Steuerung hinterlegten Algorithmus berechnet, mit welchen Betriebsparametern der ausgewählte Kontrast möglichst schnell und/ oder am besten erzeugt werden kann. In Schritt S4 wird also eine Kontrast-Inspektionsaufgabe optimiert.

In Schritt S5 erfolgt eine Aufnahme der Probe 7 mit den optimierten Betriebsparametern. Ein Benutzer des Vielstrahl-Teilchenmikroskops 1 kann dadurch optimal unterstützt werden.

### Bezugszeichenliste

- 1: Mehrstrahl-Teilchenmikroskop
- 3: primäre Teilchenstrahlen (Einzel-Teilchenstrahlen)
- 5: Strahlflecken, Auftrefforte
- 7: Objekt, Probe
- 7a: Erhebung
- 7b: Vertiefung
- 7c: Kante, Flanke
- 7d: Kante, Flanke
- 8: Probentisch
- 9: sekundäre Teilchenstrahlen
- 10: Computersystem, Steuerung
- 11: sekundärer Teilchenstrahlengang
- 13: primärer Teilchenstrahlengang
- 100: Objektivlinsensystem
- 101: Objektebene
- 102: Objektivlinse
- 103: Feld
- 110: Apertur
- 200: Detektorsystem
- 205: Projektionslinse
- 207: Szintillatorplatte
- 208: Ablenker für Justage
- 209: Detektionssystem, Teilchen-Multidetektor
- 211: Detektionsebene
- 213: Auftrefforte, Strahlfleck der Sekundärteilchen oder des zugehörigen Photonenstrahls
- 215: Detektionsbereich
- 217: Feld
- 221: optischer Strahlengang
- 222: Kontrastblende
- 223: Lichtoptik
- 225: Linse
- 227: Spiegel
- 229: Linse
- 231: Linse
- 235: Lichtempfangsfläche, Signaleintrittsoberfläche, Detektionskanal
- 236: Verbindungspunkt
- 237: Lichtdetektionssystem
- 238: toter Bereich
- 239: Glasfaser, Lichtleiter
- 241: Lichtdetektor
- 243: Bereich für optische Abbildung der Szintillatoroberfläche
- 245: Leitung
- 280: Strahlkegel
- 300: Strahlerzeugungsvorrichtung
- 301: Teilchenquelle
- 303: Kollimationslinsensystem
- 305: Multiaperturanordnung
- 306: Mikrooptik
- 307: Feldlinsensystem
- 309: divergierender Teilchenstrahl
- 310: Multistrahl-Generator
- 311: beleuchtender Teilchenstrahl
- 313: Multiaperturplatte
- 314: Multi-Feldlinse
- 315: Öffnungen der Multiaperturplatte
- 317: Mittelpunkte der Öffnungen
- 319: Feld
- 320: Multi-Stigmator
- 323: Strahlfoki
- 325: Zwischenbildebene
- 330: Multi-Fokus-Korrekturmittel
- 380: positive Aufladung
- 381: negative Aufladung
- 400: Strahlweiche
- 501: schmaler Streifen
- 502: breiter Streifen
- 503: dunkler Streifen zur Darstellung einer abfallenden Kante
- 504: heller Streifen zur Darstellung einer ansteigenden Kante
- 505: Probenbereich
- 506: Probenbereich
- 507: Probenbereich
- 510: Strahl-Selektor
- A: Achse
- E_{f}: Fokusebene
- b: Strukturbreite
- S1: Aufnehmen einer Probe mit möglichst wenigen defokussierten zweiten Einzel-Teilchenstrahlen und möglichst vielen Detektionskanälen pro zweitem Einzel-Teilchenstrahl
- S2: Erzeugen und Darstellen von verschiedenen Kontrastbildern
- S3: Auswählen eines gewünschten Kontrastes oder Kontrastbildes
- S4: Optimieren der Kontrast-Inspektionsaufgabe
- S5: Aufnehmen einer Probe mit optimierten Betriebsparametern

## Patentansprüche

1. Verfahren zum Betreiben eines Vielstrahl-Teilchenmikroskops (1), das die folgenden Schritte aufweist:
Betreiben des Vielstrahl-Teilchenmikroskops (1) in einem Kontrast-Betriebsmodus, wobei in dem Kontrast-Betriebsmodus im Sekundärpfad des Vielstrahl-Teilchenmikroskops (1) im Bereich einer Strahlüberkreuzung der Sekundärstrahlen (9) eine Kontrastapertur (222) angeordnet ist, die ein Filtern von von einem Objekt (7) startenden oder ausgehenden Sekundärteilchen nach ihren Startwinkeln ermöglicht, umfassend die folgenden Schritte:
Bestrahlen eines Objektes (7) mit einer Vielzahl von geladenen ersten Einzel-Teilchenstrahlen (3), wobei jeder erste Einzel-Teilchenstrahl (3) einen separaten Einzelfeldbereich des Objektes (7) rasternd bestrahlt;
Aufsammeln von zweiten Einzel-Teilchenstrahlen (9), die aufgrund der ersten Einzel-Teilchenstrahlen (3) aus dem Objekt (7) austreten oder die von ihm ausgehen;
Defokussiertes Projizieren der zweiten Einzel-Teilchenstrahlen (9) auf Detektionsbereiche (215) einer Detektionseinheit (207, 209) derart, dass die von zwei verschiedenen Einzelfeldbereichen austretenden zweiten Einzel-Teilchenstrahlen (9) auf verschiedene Detektionsbereiche (215) projiziert werden, wobei jedem Detektionsbereich (215) eine Mehrzahl von Detektionskanälen (235) zugeordnet ist, wobei die Detektionskanäle (235) jeweils Winkelinformation und/ oder Richtungsinformation der zweiten Einzel-Teilchenstrahlen (9) beim Starten von dem Objekt (7) kodieren, wobei bei dem defokussierten Projizieren der zweiten Einzel-Teilchenstrahlen (9) auf die Detektionsbereiche (215) der Detektionseinheit (207, 209) ein Übersprechen der zweiten Einzel-Teilchenstrahlen (9) vermieden wird; und
Erzeugen von Einzelbildern von jedem der Einzelfeldbereiche basierend auf Daten, die mittels Signalen aus jedem der Detektionsbereiche (215) mit ihren jeweils zugeordneten Detektionskanälen (235) gewonnenen werden oder gewonnen worden sind.

2. Verfahren gemäß dem vorangehenden Anspruch, das des Weiteren im Kontrast-Betriebsmodus die folgenden Schritte aufweist:
Festlegen von Gewichtungen für Signale aus jedem Detektionskanal (235); und
Mixen der Signale aus den Detektionskanälen (235) zu einem Mix-Signal des zugeordneten Detektionsbereichs (215) basierend auf den Gewichtungen.

3. Verfahren gemäß einem der vorangehenden Ansprüche, das des Weiteren im Kontrast-Betriebsmodus den folgenden Schritt aufweist:
Einstellen der Defokussierung der zweiten Einzel-Teilchenstrahlen (9) beim Auftreffen auf die Detektionseinheit (207, 209), insbesondere basierend auf der ausgewählten Kontrastblende (222); und/ oder
Auswählen einer Anzahl von Detektionskanälen (235) je Detektionsbereich (215).

4. Verfahren gemäß einem der vorangehenden Ansprüche 2 bis 3, das des Weiteren im Kontrast-Betriebsmodus den folgenden Schritt aufweist:
Einstellen eines Pitches der zweiten Einzel-Teilchenstrahlen (9) beim Auftreffen auf die Detektionseinheit (207, 209) basierend auf der ausgewählten Kontrastblende (222) und/ oder der eingestellten Defokussierung und/ oder der ausgewählten Anzahl der Detektionskanäle (235) je Detektionsbereich (215).

5. Verfahren gemäß einem der vorangehenden Ansprüche, das des Weiteren im Kontrast-Betriebsmodus den folgenden Schritt aufweist:
Auswählen einer Anzahl von Einzel-Teilchenstrahlen (9), die in dem Kontrast-Betriebsmodus auf die Detektionseinheit (207, 209) auftreffen; und/ oder
Ausblenden aller übrigen Einzel-Teilchenstrahlen (9).

6. Verfahren gemäß einem der vorangehenden Ansprüche, das des Weiteren im Kontrast-Betriebsmodus den folgenden Schritt aufweist:
Ausrichten der defokussierten zweiten Einzel-Teilchenstrahlen (9) beim Auftreffen auf die Detektionseinheit (207, 209) derart, dass die Hauptstrahlen der zweiten Einzel-Teilchenstrahlen (9) im Wesentlichen exakt mittig auf einen Detektionskanal (235) ausgerichtet werden; oder
Ausrichten der defokussierten zweiten Einzel-Teilchenstrahlen (9) beim Auftreffen auf die Detektionseinheit (207, 209) derart, dass die Hauptstrahlen der zweiten Einzel-Teilchenstrahlen (9) im Wesentlichen symmetrisch mittig zwischen Auftreffflächen von Detektionskanälen (235) ausgerichtet werden.

7. Verfahren gemäß einem der vorangehenden Ansprüche, das des Weiteren im Kontrast-Betriebsmodus den folgenden Schritt aufweist:
Kodieren der Einzelbilder in einem Falschfarbencode basierend auf Signalen aus den Detektionsbereichen (215) und/ oder den Detektionskanälen (235); und/ oder
Darstellen der Einzelbilder in einer perspektivischen Darstellung oder in einer 3D-Darstellung.

8. Verfahren gemäß einem der vorangehenden Ansprüche, das des Weiteren im Kontrast-Betriebsmodus den folgenden Schritt aufweist:
Bereitstellen einer Anordnung von Detektionskanälen (235), die richtungssensitv und/ oder radialsensitiv ist.

9. Verfahren gemäß einem der vorangehenden Ansprüche, das des Weiteren den folgenden Schritt aufweist:
Betreiben des Vielstrahl-Teilchenmikroskopes (1) in einem Normal-Inspektionsmodus, umfassend die folgenden Schritte:
Bestrahlen eines Objektes (7) mit einer Vielzahl von geladenen ersten Einzel-Teilchenstrahlen (3), wobei jeder erste Einzel-Teilchenstrahl einen separaten Einzelfeldbereich des Objektes (7) rasternd bestrahlt;
Aufsammeln von zweiten Einzel-Teilchenstrahlen (9), die aufgrund der ersten Einzel-Teilchenstrahlen (3) aus dem Objekt (7) austreten oder die von ihm ausgehen;
Fokussiertes Projizieren der zweiten Einzel-Teilchenstrahlen (9) auf Detektionsbereiche (215) einer Detektionseinheit (207, 209) derart, dass die von zwei verschiedenen Einzelfeldbereichen austretenden zweiten Einzel-Teilchenstrahlen (9) auf verschiedene Detektionsbereiche (215) projiziert werden, wobei jedem Detektionsbereich (215) genau ein Detektionskanal (235) zugeordnet ist; und
Erzeugen von Einzelbildern von jedem der Einzelfeldbereiche basierend auf Daten, die mittels Signalen aus jedem der Detektionsbereiche (215) mit ihrem jeweils zugeordneten Detektionskanal (235) gewonnenen werden oder gewonnen worden sind.

10. Verfahren gemäß dem vorangehenden Anspruch,
wobei zwischen einem Betreiben des Vielstrahl-Teilchenmikroskops (1) im Kontrast-Betriebsmodus und im Normal-Inspektionsmodus gewechselt wird.

11. Verfahren gemäß einem der vorangehenden Ansprüche,
wobei in einer Steuerung (10) des Vielstrahl-Teilchenmikroskops (1) verschiedene Kontrast-Betriebsmodi mit zugehörigen Betriebsparametern hinterlegt sind und wobei das Verfahren des Weiteren den folgenden Schritt aufweist:
Auswählen eines Kontrast-Betriebsmodus und Betreiben des Vielstrahl-Teilchenmikroskops (1) in diesem Kontrast-Betriebsmodus.

12. Vielstrahl-Teilchenmikroskop (1), das Folgendes aufweist:
eine Vielstrahl-Teilchenquelle (305), welche konfiguriert ist, um ein erstes Feld (319) einer Vielzahl von geladenen ersten Einzel-Teilchenstrahlen (3) zu erzeugen;
eine erste Teilchenoptik mit einem ersten teilchenoptischen Strahlengang (13), die konfiguriert ist, um die erzeugten ersten Einzel-Teilchenstrahlen (3) auf eine Objektebene (101) abzubilden, so dass die ersten Einzel-Teilchenstrahlen (3) an Auftrefforten (5) auf ein Objekt (7) treffen, die ein zweites Feld (103) bilden;
ein Detektionssystem (207, 209) mit einer Vielzahl von Detektionsbereichen (215), die ein drittes Feld bilden (217);
eine zweite Teilchenoptik mit einem zweiten teilchenoptischen Strahlengang (11), die konfiguriert ist, um zweite Einzel-Teilchenstrahlen (9), die von den Auftrefforten (5) im zweiten Feld (103) ausgehen, auf das dritte Feld (217) der Detektionsbereiche (215) des Detektionssystems (207, 209) abzubilden;
eine magnetische Objektivlinse (102), durch die sowohl die ersten (3) als auch die zweiten Einzel-Teilchenstrahlen (9) hindurchtreten;
eine Strahlweiche (400), die in dem ersten teilchenoptischen Strahlengang (13) zwischen der Vielstrahl-Teilchenquelle (305) und der Objektivlinse (102) angeordnet ist, und die im zweiten teilchenoptischen Strahlengang (11) zwischen der Objektivlinse (102) und dem Detektionssystem (207, 209) angeordnet ist;
eine Modus-Auswahleinrichtung, die eingerichtet ist, eine Auswahl zwischen einem Normal-Betriebsmodus und einem Kontrast-Betriebsmodus zu treffen; und
eine Steuerung (10);
wobei in dem zweiten teilchenoptischen Strahlengang (11) zwischen der Strahlweiche (400) und dem Detektionssystem (207, 209) eine Strahlüberkreuzung der zweiten Einzel-Teilchenstrahlen (9) angeordnet ist,
wobei im Bereich der Strahlüberkreuzung eine Kontrastapertur (222) zum Filtern der zweiten Einzel-Teilchenstrahlen (9) nach ihren Startwinkeln von der Objektebene (101) angeordnet ist,
wobei die Steuerung (10) konfiguriert ist, die zweite Teilchenoptik in dem Normal-Betriebsmodus derart anzusteuern, dass die zweiten Einzel-Teilchenstrahlen (9) im Wesentlichen fokussiert auf die Detektionsbereiche (215) auftreffen, wobei in dem Normal-Betriebsmodus jedem Detektionsbereich (215) genau ein Detektionskanal (235) zur Signalauswertung zugeordnet ist, und
wobei die Steuerung (10) konfiguriert ist, die zweite Teilchenoptik in dem Kontrast-Betriebsmodus derart anzusteuern, dass zumindest einer oder einige oder alle der zweiten Einzel-Teilchenstrahlen (9) defokussiert auf die Detektionsbereiche (215) auftreffen, wobei in dem Kontrast-Betriebsmodus jedem Detektionsbereich eine Mehrzahl von Detektionskanälen zur Signalauswertung zugeordnet ist, wobei bei dem defokussierten Auftreffen der zweiten Einzel-Teilchenstrahlen (9) auf die Detektionsbereiche (215) der Detektionseinheit (207, 209) ein Übersprechen der zweiten Einzel-Teilchenstrahlen (9) vermieden wird,
wobei die Mehrzahl der Detektionskanäle (235) jeweils so angeordnet ist, dass eine winkelabhängige und/ oder richtungsabhängige Detektion von zweiten Einzel-Teilchenstrahlen (9) in dem Kontrast-Betriebsmodus erfolgen kann.

13. Vielstrahl-Teilchenmikroskop (1) gemäß dem vorangehenden Anspruch,
wobei das Detektionssystem (207, 209) aus einem oder mehreren Teilchendetektoren besteht; oder
wobei das Detektionssystem (207, 209) einen oder mehrere Teilchendetektoren sowie mehrere diesem oder diesen nachgeschaltete Lichtdetektoren aufweist.

14. Vielstrahl-Teilchenmikroskop (1) gemäß dem vorangehenden Anspruch,
wobei das Detektionssystem (207, 209) einen oder mehrere Teilchendetektoren sowie mehrere diesem oder diesen nachgeschaltete Lichtdetektoren aufweist, und
wobei jeder Detektionskanal (235) genau eine Glasfaser (239) aufweist und wobei verschiedene Detektionskanäle (235) verschiedene Glasfasern (239) aufweisen.

15. Vielstrahl-Teilchenmikroskop (1) gemäß dem vorangehenden Anspruch,
wobei mehrere Detektionskanäle (235) zumindest teilweise miteinander verbunden sind, insbesondere mittels Laserweißen, wobei die verbundenen Detektionskanäle (235) im Kontrast-Betriebsmodus demselben Detektionsbereich (215) zugeordnet sein können.

16. Vielstrahl-Teilchenmikroskop (1) gemäß Anspruch 13,
wobei das Detektionssystem (207, 209) einen oder mehrere Teilchendetektoren sowie mehrere diesem oder diesen nachgeschaltete Lichtdetektoren aufweist, und
wobei ein Detektionskanal (235) keine Glasfaser aufweist und wobei als Lichtdetektions-system ein Array aus lichtsensitiven Detektoren, insbesondere ein Array umfassend Fotomultiplier, Fotodioden oder Avalanche-Fotodioden, vorgesehen ist.

17. Vielstrahl-Teilchenmikroskop (1) gemäß einem der Ansprüche 12 bis 16,
wobei jeder Detektionskanal (235) eine Signaleintrittsoberfläche aufweist, die kreisförmig oder dreieckig oder hexagonal ist.

18. Vielstrahl-Teilchenmikroskop (1) gemäß dem vorangehenden Anspruch,
wobei die Signaleintrittsoberflächen der Detektionskanäle (235) eine hexagonal dichteste Anordnung aufweisen und/ oder die Signaleintrittsoberflächen insgesamt als Hexagon angeordnet sind.

19. Vielstrahl-Teilchenmikroskop (9) gemäß einem der Ansprüche 12 bis 18,
wobei im Kontrast-Betriebsmodus einem Detektionsbereich (215) drei oder vier oder sechs Detektionskanäle (235) zugeordnet sind.

20. Vielstrahl-Teilchenmikroskop (1) gemäß einem der Ansprüche 12 bis 19,
wobei im Kontrast-Betriebsmodus einem Detektionsbereich (215) mindestens zwei Schalen einer konzentrischen schalenartigen Anordnung von Signaleintrittsoberflächen zugeordnet sind.

21. Vielstrahl-Teilchenmikroskop (1) gemäß Anspruch 20,
wobei die Anordnung der Signaleintrittsoberflächen der Detektionskanäle (235) hexagonal ist und die innerste Schale genau 1, genau 7 oder genau 19 Detektionskanäle (235) umfasst; oder
wobei die Anordnung der Signaleintrittsoberflächen der Detektionskanäle (235) hexagonal ist und die innerste Schale genau 6 oder genau 24 Detektionskanäle (235) umfasst; oder
wobei die Anordnung der Signaleintrittsoberflächen der Detektionskanäle (235) rechteckig ist und die innerste Schale genau 1 oder genau 9 oder genau 16 Detektionskanäle (235) umfasst.

22. Computerprogrammprodukt mit einem Programmcode, umfassend Befehle, die bewirken, dass die Vorrichtung gemäß Anspruch 12 die Verfahrensschritte des Anspruchs 1 ausführt.

## Claims

1. Method for operating a multi-beam particle microscope (1), including the following steps:
operating the multi-beam particle microscope (1) in a contrast operating mode, wherein, in the contrast operating mode, a contrast aperture (222) is arranged in the secondary path of the multi-beam particle microscope (1) in the region of a beam cross-over of the secondary beams (9), and enables secondary particles starting or emanating from an object (7) to be filtered according to their starting angles, comprising the following steps:
irradiating an object (7) with a multiplicity of charged first individual particle beams (3), wherein each first individual particle beam (3) irradiates a separate individual field region of the object (7) in a scanning fashion;
collecting second individual particle beams (9) which emerge from the object (7) on account of the first individual particle beams (3) or which emanate from said object;
defocused projecting of the second individual particle beams (9) onto detection regions (215) of a detection unit (207, 209) in such a way that the second individual particle beams (9) emerging from two different individual field regions are projected onto different detection regions (215), wherein a plurality of detection channels (235) are assigned to each detection region (215), wherein the detection channels (235) each encode angle information and/or direction information of the second individual particle beams (9) when starting from the object (7), wherein crosstalk of the second individual particle beams (9) is avoided during the defocused projecting of the second individual particle beams (9) onto the detection regions (215) of the detection unit (207, 209); and
generating individual images of each of the individual field regions on the basis of data which are obtained or have been obtained by means of signals from each of the detection regions (215) with their respectively assigned detection channels (235).

2. Method according to the preceding claim, furthermore including the following steps in the contrast operating mode:
defining weightings for signals from each detection channel (235); and
mixing the signals from the detection channels (235) to form a mixed signal of the assigned detection region (215) on the basis of the weightings.

3. Method according to either of the preceding claims, furthermore including the following step in the contrast operating mode:
setting the defocusing of the second individual particle beams (9) upon incidence on the detection unit (207, 209), in particular on the basis of the selected contrast stop (222); and/or
selecting a number of detection channels (235) per detection region (215).

4. Method according to either of the preceding Claims 2 and 3, furthermore including the following step in the contrast operating mode:
setting a pitch of the second individual particle beams (9) upon incidence on the detection unit (207, 209) on the basis of the selected contrast stop (222) and/or the set defocusing and/or the selected number of detection channels (235) per detection region (215).

5. Method according to either of the preceding claims, furthermore including the following step in the contrast operating mode:
selecting a number of individual particle beams (9) which are incident on the detection unit (207, 209) in the contrast operating mode; and/or
masking out all other individual particle beams (9).

6. Method according to either of the preceding claims, furthermore including the following step in the contrast operating mode:
aligning the defocused second individual particle beams (9) upon incidence on the detection unit (207, 209) in such a way that the chief rays of the second individual particle beams (9) are aligned substantially exactly centrally with a detection channel (235); or
aligning the defocused second individual particle beams (9) upon incidence on the detection unit (207, 209) in such a way that the chief rays of the second individual particle beams (9) are aligned substantially symmetrically centrally between incidence surfaces of detection channels (235).

7. Method according to either of the preceding claims, furthermore including the following step in the contrast operating mode:
encoding the individual images in a false colour code on the basis of signals from the detection regions (215) and/or the detection channels (235); and/or
representing the individual images in a perspective representation or in a 3D representation.

8. Method according to either of the preceding claims, furthermore including the following step in the contrast operating mode:
providing an arrangement of detection channels (235) which is direction-sensitive and/or radially sensitive.

9. Method according to any of the preceding claims, furthermore including the following step:
operating the multi-beam particle microscope (1) in a normal inspection mode, comprising the following steps:
irradiating an object (7) with a multiplicity of charged first individual particle beams (3), wherein each first individual particle beam irradiates a separate individual field region of the object (7) in a scanning fashion;
collecting second individual particle beams (9) which emerge from the object (7) on account of the first individual particle beams (3) or which emanate from said object;
focused projecting of the second individual particle beams (9) onto detection regions (215) of a detection unit (207, 209) in such a way that the second individual particle beams (9) emerging from two different individual field regions are projected onto different detection regions (215), wherein exactly one detection channel (235) is assigned to each detection region (215); and
generating individual images of each of the individual field regions on the basis of data which are obtained or have been obtained by means of signals from each of the detection regions (215) with their respectively assigned detection channel (235).

10. Method according to the preceding claim,
wherein the method changes between operating the multi-beam particle microscope (1) in the contrast operating mode and in the normal inspection mode.

11. Method according to any of the preceding claims,
wherein various contrast operating modes with associated operating parameters are stored in a controller (10) of the multi-beam particle microscope (1) and wherein the method furthermore includes the following step:
selecting a contrast operating mode and operating the multi-beam particle microscope (1) in this contrast operating mode.

12. Multi-beam particle microscope (1), comprising the following:
a multi-beam particle source (305), which is configured to generate a first field (319) of a multiplicity of charged first individual particle beams (3);
a first particle optical unit with a first particle optical beam path (13), configured to image the generated first individual particle beams (3) onto an object plane (101) such that the first individual particle beams (3) strike an object (7) at incidence locations (5), which form a second field (103);
a detection system (207, 209) with a multiplicity of detection regions (215) that form a third field (217);
a second particle optical unit with a second particle optical beam path (11), configured to image second individual particle beams (9), which emanate from the incidence locations (5) in the second field (103), onto the third field (217) of the detection regions (215) of the detection system (207, 209);
a magnetic objective lens (102), through which both the first (3) and the second individual particle beams (9) pass;
a beam switch (400), which is arranged in the first particle optical beam path (13) between the multi-beam particle source (305) and the objective lens (102) and which is arranged in the second particle optical beam path (11) between the objective lens (102) and the detection system (207, 209);
a mode selection device configured to make a selection between a normal operating mode and a contrast operating mode; and
a controller (10);
wherein a beam cross-over of the second individual particle beams (9) is arranged in the second particle optical beam path (11) between the beam switch (400) and the detection system (207, 209),
wherein a contrast aperture (222) for filtering the second individual particle beams (9) according to their starting angles from the object plane (101) is arranged in the region of the beam cross-over,
wherein the controller (10) is configured to control the second particle optical unit in the normal operating mode in such a way that the second individual particle beams (9) are incident on the detection regions (215) substantially in a focused fashion, wherein in the normal operating mode each detection region (215) is assigned exactly one detection channel (235) for signal evaluation, and
wherein the controller (10) is configured to control the second particle optical unit in the contrast operating mode in such a way that at least one or some or all of the second individual particle beams (9) are incident on the detection regions (215) in a defocused fashion, wherein, in the contrast operating mode, each detection region is assigned a plurality of detection channels for signal evaluation, wherein crosstalk of the second individual particle beams (9) is avoided during the defocused incidence of the second individual particle beams (9) on the detection regions (215) of the detection unit (207, 209),
wherein each of the plurality of the detection channels (235) is arranged such that an angle-dependent and/or direction-dependent detection of second individual particle beams (9) can take place in the contrast operating mode.

13. Multi-beam particle microscope (1) according to the preceding claim,
wherein the detection system (207, 209) consists of one or more particle detectors; or
wherein the detection system (207, 209) comprises one or more particle detectors and also a plurality of light detectors disposed downstream thereof.

14. Multi-beam particle microscope (1) according to the preceding claim,
wherein the detection system (207, 209) comprises one or more particle detectors and also a plurality of light detectors disposed downstream thereof, and
wherein each detection channel (235) comprises exactly one optical fibre (239) and wherein different detection channels (235) comprise different optical fibres (239).

15. Multi-beam particle microscope (1) according to the preceding claim,
wherein a plurality of detection channels (235) are at least partly connected to one another, in particular by means of laser welding, wherein the connected detection channels (235) can be assigned to the same detection region (215) in the contrast operating mode.

16. Multi-beam particle microscope (1) according to Claim 13,
wherein the detection system (207, 209) comprises one or more particle detectors and also a plurality of light detectors disposed downstream thereof, and
wherein one detection channel (235) comprises no optical fibre and wherein an array of light-sensitive detectors, in particular an array comprising photomultipliers, photodiodes or avalanche photodiodes, is provided as the light detection system.

17. Multi-beam particle microscope (1) according to any of Claims 12 to 16,
wherein each detection channel (235) has a signal entrance surface that is circular or triangular or hexagonal.

18. Multi-beam particle microscope (1) according to the preceding claim,
wherein the signal entrance surfaces of the detection channels (235) have a hexagonally close packed arrangement and/or the signal entrance surfaces are arranged overall as a hexagon.

19. Multi-beam particle microscope (9) according to any of Claims 12 to 18,
wherein three or four or six detection channels (235) are assigned to a detection region (215) in the contrast operating mode.

20. Multi-beam particle microscope (1) according to any of Claims 12 to 19,
wherein at least two shells of a concentric shell-like arrangement of signal entrance surfaces are assigned to a detection region (215) in the contrast operating mode.

21. Multi-beam particle microscope (1) according to Claim 20,
wherein the arrangement of the signal entrance surfaces of the detection channels (235) is hexagonal and the innermost shell comprises exactly 1, exactly 7 or exactly 19 detection channels (235); or
wherein the arrangement of the signal entrance surfaces of the detection channels (235) is hexagonal and the innermost shell comprises exactly 6 or exactly 24 detection channels (235); or
wherein the arrangement of the signal entrance surfaces of the detection channels (235) is rectangular and the innermost shell comprises exactly 1 or exactly 9 or exactly 16 detection channels (235).

22. Computer program product having a program code, comprising instructions which cause the apparatus according to Claim 12 to execute the method steps of Claim 1.

## Revendications

1. Procédé de fonctionnement d'un microscope à particules à faisceaux multiples (1), qui comporte les étapes suivantes :
fonctionnement du microscope à particules à faisceaux multiples (1) dans un mode de fonctionnement par contraste, une ouverture de contraste (222) étant disposée, dans le mode de fonctionnement par contraste, sur le trajet secondaire du microscope à particules à faisceaux multiples (1) dans la zone d'un croisement de faisceaux des faisceaux secondaires (9), laquelle permet de filtrer des particules secondaires partant depuis un objet (7) ou en sortant selon leurs angles de départ, comprenant les étapes suivantes :
irradiation d'un objet (7) à une pluralité de premiers faisceaux de particules individuels (3) chargés, chaque premier faisceau de particules individuel (3) irradiant de manière quadrillée une zone de champ individuelle distincte de l'objet (7),
collecte de deuxièmes faisceaux de particules individuels (9), qui sortent de l'objet (7) ou qui partent de celui-ci du fait des premiers faisceaux de particules individuels (3),
projection défocalisée des deuxièmes faisceaux de particules individuels (9) sur des zones de détection (215) d'une unité de détection (207, 209) de telle manière que les deuxièmes faisceaux de particules individuels (9) sortant de deux zones de champ individuelles différentes sont projetés sur des zones de détection (215) différentes, une multitude de canaux de détection (235) étant associée à chaque zone de détection (215), les canaux de détection (235) codant chacun des informations d'angle et/ou des informations de direction des deuxièmes faisceaux de particules individuels (9) au départ de l'objet (7), une diaphonie des deuxièmes faisceaux de particules individuels (9) étant évitée lors de la projection défocalisée des deuxièmes faisceaux de particules individuels (9) sur les zones de détection (215) l'unité de détection (207, 209) ; et
génération d'images individuelles de chacune des zones de champ individuelles sur la base de données, qui sont obtenues ou ont été obtenues au moyen de signaux provenant de chacune des zones de détection (215) avec leurs canaux de détection (235) respectivement associés.

2. Procédé selon la revendication précédente, qui comporte par ailleurs dans le mode de fonctionnement par contraste les étapes suivantes :
définition de pondérations pour des signaux provenant de chaque canal de détection (235) ; et
mélange des signaux provenant des canaux de détection (235) en un signal de mélange de la zone de détection (215) associée sur la base des pondérations.

3. Procédé selon l'une des revendications précédentes, qui comporte par ailleurs dans le mode de fonctionnement par contraste l'étape suivante :
réglage de la défocalisation des deuxièmes faisceaux de particules individuels (9) lors de l'impact sur l'unité de détection (207, 209), en particulier sur la base du diaphragme de contraste (222) sélectionné ; et/ou
sélection d'un certain nombre de canaux de détection (235) par zone de détection (215).

4. Procédé selon l'une des revendications précédentes 2 à 3, qui comporte par ailleurs dans le mode de fonctionnement par contraste l'étape suivante :
réglage d'un pas des deuxièmes faisceaux de particules individuels (9) lors de l'impact sur l'unité de détection (207, 209) sur la base du diaphragme de contraste (222) sélectionné et/ou de la défocalisation réglée et/ou du nombre sélectionné de canaux de détection (235) par zone de détection (215).

5. Procédé selon l'une des revendications précédentes, qui comporte par ailleurs dans le mode de fonctionnement par contraste l'étape suivante :
sélection d'un certain nombre de faisceaux de particules individuels (9), qui impactent l'unité de détection (207, 209) dans le mode de fonctionnement par contraste ; et/ou
masquage de tous les faisceaux de particules individuels (9) restants.

6. Procédé selon l'une des revendications précédentes, qui comporte par ailleurs dans le mode de fonctionnement par contraste l'étape suivante :
orientation des deuxièmes faisceaux de particules individuels (9) défocalisés lors de l'impact sur l'unité de détection (207, 209) de telle manière que les faisceaux principaux des deuxièmes faisceaux de particules individuels (9) sont orientés sensiblement exactement au milieu d'un canal de détection (235) ; ou
orientation des deuxièmes faisceaux de particules individuels (9) défocalisés lors de l'impact sur l'unité de détection (207, 209) de telle manière que les faisceaux principaux des deuxièmes faisceaux de particules individuels (9) sont orientés de manière sensiblement symétrique au milieu entre des surfaces d'impact de canaux de détection (235).

7. Procédé selon l'une des revendications précédentes, qui comporte par ailleurs dans le mode de fonctionnement par contraste l'étape suivante :
codage des images individuelles dans un code de fausses couleurs sur la base de signaux provenant des zones de détection (215) et/ou des canaux de détection (235) ; et/ou
représentation des images individuelles dans une vue en perspective ou dans une vue 3D.

8. Procédé selon l'une des revendications précédentes, qui comporte par ailleurs dans le mode de fonctionnement par contraste l'étape suivante :
fourniture d'un ensemble de canaux de détection (235), qui sont sensibles à la direction et/ou sensibles au rayonnement.

9. Procédé selon l'une des revendications précédentes, qui comporte par ailleurs l'étape suivante :
fonctionnement du microscope à particules à faisceaux multiples (1) dans un mode d'inspection normal, comprenant les étapes suivantes :
irradiation d'un objet (7) avec une pluralité de premiers faisceaux de particules individuels (3) chargés, chaque premier faisceau de particules individuel irradiant de manière quadrillée une zone de champ individuelle distincte de l'objet (7) ;
collecte de deuxièmes faisceaux de particules individuels (9), qui sortent de l'objet (7) ou qui partent de celui-ci du fait des premiers faisceaux de particules individuels (3),
projection focalisée des deuxièmes faisceaux de particules individuels (9) sur des zones de détection (215) d'une unité de détection (207, 209) de telle manière que les deuxièmes faisceaux de particules individuels (9) sortant de deux zones de champ individuelles différentes sont projetés sur des zones de détection (215) différentes, un canal de détection (235) précisément étant associé à chaque zone de détection (215) ; et
génération d'images individuelles de chacune des zones de champ individuelles sur la base de données, qui sont obtenues ou ont été obtenues au moyen de signaux provenant de chacune des zones de détection (215) avec leur canal de détection (235) respectivement associé.

10. Procédé selon la revendication précédente,
le microscope à particules à faisceaux multiples (1) fonctionnant en alternance dans le mode de fonctionnement par contraste et dans le mode d'inspection normal.

11. Procédé selon l'une des revendications précédentes,
différents modes de fonctionnement par contraste avec des paramètres de fonctionnement associés étant enregistrés dans une commande (10) du microscope à particules à faisceaux multiples (1) et le procédé comportant par ailleurs l'étape suivante :
sélection d'un mode de fonctionnement par contraste et fonctionnement du microscope à particules à faisceaux multiples (1) dans ledit mode de fonctionnement par contraste.

12. Microscope à particules à faisceaux multiples (1), qui comporte ce qui suit :
une source de particules à faisceaux multiples (305), qui est configurée pour générer un premier champ (319) d'une pluralité de premiers faisceaux de particules individuels (3) chargés ;
une première optique à particules avec un premier chemin optique de particules (13), qui est configurée pour reproduire les premiers faisceaux de particules individuels (3) générés sur un plan d'objet (101) de telle sorte que les premiers faisceaux de particules individuels (3) rencontrent un objet (7) sur des points d'impact (5), qui forment un deuxième champ (103) ;
un système de détection (207, 209) avec une pluralité de zones de détection (215), qui forment un troisième champ (217) ;
une deuxième optique à particules avec un deuxième chemin optique de particules (11), qui est configurée pour reproduire des deuxièmes faisceaux de particules individuels (9), qui partent des points d'impact (5) dans le deuxième champ (103), sur le troisième champ (217) des zones de détection (215) du système de détection (207, 209) ;
une lentille d'objectif magnétique (102), qui est traversée à la fois par les premiers (3) et les deuxièmes (9) faisceaux de particules individuels ;
un commutateur de faisceau (400), qui est disposé dans le premier chemin optique de particules (13) entre la source de particules à faisceaux multiples (305) et la lentille d'objectif (102) et qui est disposé dans le deuxième chemin optique de particules (11) entre la lentille d'objectif (102) et le système de détection (207, 209) ;
un équipement de sélection de mode, qui est mis au point pour choisir entre un mode de fonctionnement normal et un mode de fonctionnement par contraste ; et
une commande (10) ;
un croisement de faisceaux des deuxièmes faisceaux de particules individuels (9) étant disposé dans le deuxième chemin optique de particules (11) entre le commutateur de faisceau (400) et le système de détection (207, 209),
une ouverture de contraste (222) destinée à filtrer les deuxièmes faisceaux de particules individuels (9) selon leurs angles de départ depuis le plan objet (101) étant disposée dans la zone du croisement des faisceaux,
la commande (10) étant configurée pour piloter la deuxième optique à particules dans le mode de fonctionnement normal de telle manière que les deuxièmes faisceaux de particules individuels (9) rencontrent de manière sensiblement focalisée les zones de détection (215), précisément un canal de détection (235) étant associé pour l'évaluation de signaux, à chaque zone de détection (215) dans le mode de fonctionnement normal, et
la commande (10) étant configurée pour piloter la deuxième optique à particules dans le mode de fonctionnement par contraste de telle manière qu'au moins un ou une partie ou la totalité des deuxièmes faisceaux de particules individuels (9) rencontrent de manière défocalisée les zones de détection (215), une multitude de canaux de détection étant associée pour l'évaluation de signaux à chaque zone de détection dans le mode de fonctionnement par contraste, une diaphonie des deuxièmes faisceaux de particules individuels (9) étant évitée lors de l'impact défocalisé des deuxièmes faisceaux de particules individuels (9) sur les zones de détection (215) de l'unité de détection (207, 209),
la multitude des canaux de détection (235) étant disposée respectivement de telle sorte qu'une détection dépendant de l'angle et/ou de la direction de deuxièmes faisceaux de particules individuels (9) peut être effectuée dans le mode de fonctionnement par contraste.

13. Microscope à particules à faisceaux multiples (1) selon la revendication précédente,
le système de détection (207, 209) étant constitué d'un ou de plusieurs détecteurs de particules ; ou
le système de détection (207, 209) comportant un ou plusieurs détecteurs de particules ainsi que plusieurs détecteurs de lumière montés en de celui-ci ou de ceux-ci.

14. Microscope à particules à faisceaux multiples (1) selon la revendication précédente,
le système de détection (207, 209) comportant un ou plusieurs détecteurs de particules ainsi que plusieurs détecteurs de lumière montés en aval de celui-ci ou de ceux-ci, et
chaque canal de détection (235) comportant précisément une fibre de verre (239) et différents canaux de détection (235) comportant différentes fibres de verre (239).

15. Microscope à particules à faisceaux multiples (1) selon la revendication précédente,
plusieurs canaux de détection (235) étant reliés au moins en partie les uns aux autres, en particulier par soudage au laser, les canaux de détection (235) reliés pouvant être associés dans le mode de fonctionnement par contraste à la même zone de détection (215).

16. Microscope à particules à faisceaux multiples (1) selon la revendication 13,
le système de détection (207, 209) comportant un ou plusieurs détecteurs de particules ainsi que plusieurs détecteurs de lumière montés en aval de celui-ci ou de ceux-ci, et
un canal de détection (235) ne comportant aucune fibre de verre et un réseau de détecteurs photosensibles, en particulier un réseau comprenant des photomultiplicateurs, des photodiodes ou des photodiodes à avalanche, étant prévu en tant que système de détection de lumière.

17. Microscope à particules à faisceaux multiples (1) selon l'une des revendications 12 à 16,
chaque canal de détection (235) comportant une surface d'entrée de signal, qui est circulaire ou triangulaire ou hexagonale.

18. Microscope à particules à faisceaux multiples (1) selon la revendication précédente,
les surfaces d'entrée de signal des canaux de détection (235) présentant une disposition hexagonale la plus dense et/ou les surfaces d'entrée de signal étant disposées globalement sous la forme d'un hexagone.

19. Microscope à particules à faisceaux multiples (9) selon l'une des revendications 12 à 18,
trois, quatre ou six canaux de détection (235) étant associés dans le mode de fonctionnement par contraste à une zone de détection (215).

20. Microscope à particules à faisceaux multiples (1) selon l'une des revendications 12 à 19,
au moins deux coques d'une disposition concentrique de surfaces d'entrée de signal en forme de coque étant associées dans le mode de fonctionnement par contraste à une zone de détection (215).

21. Microscope à particules à faisceaux multiples (1) selon la revendication 20,
la disposition des surfaces d'entrée de signal des canaux de détection (235) étant hexagonale et la coque la plus à l'intérieur comprenant exactement 1, exactement 7 ou exactement 19 canaux de détection (235) ; ou
la disposition des surfaces d'entrée de signal des canaux de détection (235) étant hexagonale et la coque la plus à l'intérieur comprenant exactement 6 ou exactement 24 canaux de détection (235) ; ou
la disposition des surfaces d'entrée de signal des canaux de détection (235) étant rectangulaire et la coque la plus à l'intérieur comprenant exactement 1 ou exactement 9 ou exactement 16 canaux de détection (235).

22. Produit-programme informatique avec un code de programme, comprenant des instructions qui amènent le dispositif selon la revendication 12 à exécuter les étapes de procédé de la revendication 1.
